(19) Europäisches Patentamt
European Patent Office
Office européen des brevets

(11) EP 4 658 049 A1

(12) EUROPEAN PATENT APPLICATION
published in accordance with Art. 153(4) EPC

(43) Date of publication:
**03.12.2025 Bulletin 2025/49**

(21) Application number: **24747464.6**

(22) Date of filing: **25.01.2024**

(51) International Patent Classification (IPC):
***H10K 85/30*** (2023.01) ***H10K 50/11*** (2023.01)
***H10K 50/19*** (2023.01) ***C09K 11/06*** (2006.01)
***H10K 101/20*** (2023.01)

(52) Cooperative Patent Classification (CPC):
**C09K 11/06; H10K 50/11; H10K 50/19; H10K 85/30;** H10K 2101/20

(86) International application number:
**PCT/KR2024/001209**

(87) International publication number:
**WO 2024/158230 (02.08.2024 Gazette 2024/31)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **25.01.2023 KR 20230009704**

(71) Applicant: **Lordin Co., Ltd**
**Hwaseong-si, Gyeonggi-do 18469 (KR)**

(72) Inventors:
- **PARK, Bu Bae**
  **Hwaseong-si, Gyeonggi-do 18469 (KR)**
- **HAN, Ga Ram**
  **Osan-si, Gyeonggi-do 18113 (KR)**
- **KANG, Sang Min**
  **Hwaseong-si, Gyeonggi-do 18466 (KR)**

(74) Representative: **Pfenning, Meinig & Partner mbB**
**Patent- und Rechtsanwälte**
**Theresienhöhe 11a**
**80339 München (DE)**

(54) **ORGANIC LIGHT-EMITTING DIODE**

(57) Provided is an organic light-emitting diode including a first electrode, a second electrode, and a light-emitting layer interposed between the first electrode and the second electrode, wherein the light-emitting layer includes a novel complex light-emitting compound represented by Chemical Formula 1 set forth in the detailed description.

【FIG. 1】

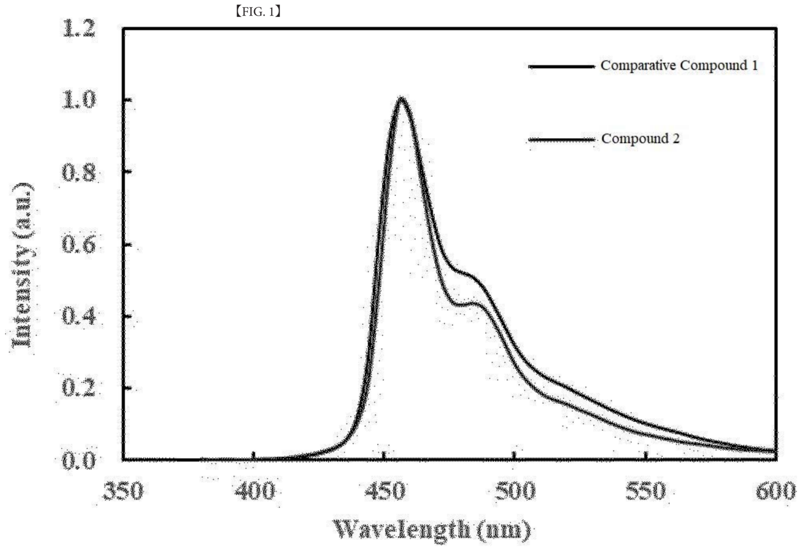


EP 4 658 049 A1

## Description

### Technical Field

The present invention relates to an organic light-emitting diode including an organic light-emitting material having a long lifetime. More specifically, the present invention relates to an organic light-emitting diode capable of minimizing a decrease in light brightness even when driven for a long period of time by improving luminescence stability of a light-emitting body.

### Background Art

An OLED (organic light-emitting diode) is a device in which holes injected from an anode and electrons injected from a cathode pass through a charge transport layer and combine in a light-emitting layer to form excitons and emit light, and was first reported in Appl. Phys. Lett 51, 913 by C. W. Tang in 1987. At that time, the light-emitting layer was formed with an $Alq_3$ single material. In J. Appl. Phys., Vol. 65, 3610 in 1989, it is disclosed that $Alq_3$ was doped with a small amount of DCM as a red light-emitting compound and a small amount of Coumarin 540 as a green light-emitting compound to adjust emission wavelengths and increase efficiency.

### DISCLOSURE

### Technical Problem

An object of the present disclosure is to provide an organic light-emitting diode capable of minimizing a decrease in light brightness even when driven for a long period of time by improving luminescence stability of a light-emitting body.

Objects of the present disclosure are not limited to the object mentioned above, and other objects and advantages of the present disclosure not mentioned herein may be understood by the following description, and will be more clearly understood by embodiments of the present disclosure. In addition, it may be readily seen that objects and advantages of the present disclosure may be embodied by means described in the claims and combinations thereof.

### Technical Solution

One embodiment of the present invention provides,

an organic light-emitting diode including: a first electrode; a second electrode; and a light-emitting layer interposed between the first electrode and the second electrode,

wherein the light-emitting layer includes a complex light-emitting compound represented by the following Chemical Formula 1,

the complex light-emitting compound includes a light-emitting moiety and a charge-stabilizing moiety, the light-emitting moiety and the charge-stabilizing moiety are linked through atom X, and atom X is X presented in the following Chemical Formula 1,

the light-emitting moiety includes A, a conjugated ring formed to include $Y^1$ to $Y^5$, and Q in the following Chemical Formula 1,

the charge-stabilizing moiety includes a ring formed to include $Y^6$ to $Y^{10}$, a ring formed to include $Y^{11}$ to $Y^{15}$, and Z in the following Chemical Formula 1, and

the charge-stabilizing moiety includes at least one atom having an unshared electron pair:

<Chemical Formula 1>

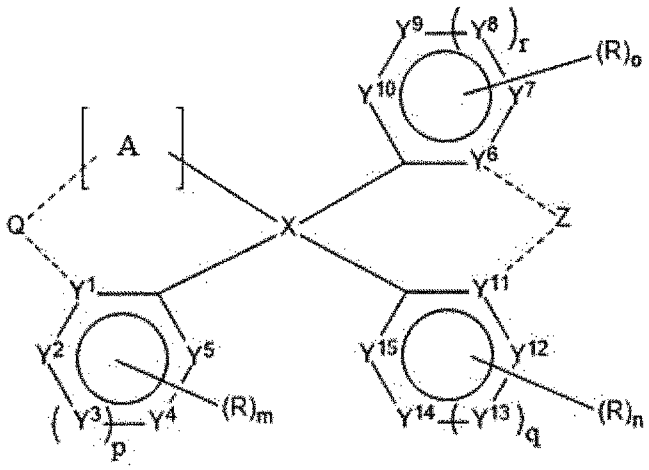

In Chemical Formula 1,

A is a structure represented by the following Chemical Formula 2, and is linked through a first linking position of A, or linked through a first linking position and a second linking position of A,
X is C, Si, Ge, Sn or Pb, and the first linking position of A is linked to X,
Q is not present, or a single bond, -B($Ar^1$)-, - C($Ar^1$)($Ar^2$)-, -Si($Ar^1$)($Ar^2$)-, -Ge($Ar^1$)($Ar^2$)-, -N($Ar^1$)-, - P($Ar^1$)-, -PO($Ar^1$)-, -O-, -S-, -SO-, -$SO_2$-, -Se-, -SeO-, -$SeO_2$-, -CO-, -CS- or -CSe-, and herein, $Ar^1$ and $Ar^2$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^1$ and $Ar^2$ may be linked to each other to form a ring, or may each be linked to $Y^2$, R that is linked to $Y^2$, or A to form a fused ring,
when Q is not present, A is not directly linked to $Y^1$ at the second linking position of A,
when Q is a single bond, A is linked to $Y^1$ by a single bond at the second linking position of A,
when Q is not a single bond and is present as any one defined as above, A is linked to Q at the second linking position of A,
when Q is not a single bond and is present as any one defined as above, Q is linked to A and $Y^1$ each by a single bond,
$Y^1$ to $Y^{15}$ are each independently boron, carbon, nitrogen, oxygen, sulfur, Se or Te,
Z is not present, or a single bond, -B($Ar^3$)-, - C($Ar^3$)($Ar^4$)-, -Si($Ar^3$)($Ar^4$)-, -Ge($Ar^3$)($Ar^4$)-, -N($Ar^3$)-, - P($Ar^4$)-, -PO($Ar^3$)-, -O-, -S-, -SO-, -$SO_2$-, -Se-, -SeO-, -$SeO_2$-, -CO-, -CS- or -CSe-, and herein, $Ar^3$ and $Ar^4$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^3$ and $Ar^4$ may be linked to each other to form a ring, or may each be linked to any one of $Y^7$, $Y^{12}$, R that is linked to $Y^7$ or R that is linked to $Y^{12}$ to form a fused ring,
when Z is not present, $Y^6$ and $Y^{11}$ are not directly linked,
when Z is a single bond, $Y^6$ and $Y^{11}$ are linked by a single bond,
when Z is not a single bond and is present as any one defined as above, Z is linked to $Y^6$ and $Y^{11}$ each by a single bond,
m, n and o are each independently an integer of 0 to 5,
Rs are each independently at least one selected from the group consisting of hydrogen, deuterium, halogen, cyano, -$NO_2$, alkyl having 1 to 30 carbon atoms unsubstituted or substituted with an additional substituent, alkenyl having 2 to 30 carbon atoms unsubstituted or substituted with an additional substituent, alkynyl having 2 to 30 carbon atoms

unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heteroalkenyl having 2 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent,

allyl having 3 to 30 carbon atoms unsubstituted or substituted with an additional substituent, aryl having 6 to 30 carbon atoms unsubstituted or substituted with an additional substituent, heteroaryl having 2 to 30 carbon atoms unsubstituted or substituted with an additional substituent, $-B(R^{101})(R^{102})$, $-C(R^{103})(R^{104})(R^{105})$, $-Si(R^{106})(R^{107})(R^{108})$, $-Ge(R^{109})(R^{110})(R^{111})$, $-N(R^{112})(R^{113})$, $-P(R^{114})(R^{115})$, $-PO(R^{116})(R^{117})$, $-O(R^{118})$, $-S(R^{119})$, $-SO(R^{120})$, $-SO_2(R^{121})$, $Se(R^{122})$, $-SeO(R^{123})$, $-SeO_2(R^{124})$ and combinations thereof,

$R^{101}$ to $R^{124}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and at least two of $R^{101}$ to $R^{124}$ linked to one atom may be linked to form a ring,

at least two Rs present when m, n or o is 2 or greater may be linked to each other to form a ring,

p, q and r each independently represent 0 or 1, and when p, q or r is 0, it means that a 5-membered ring is formed, and when p, q or r is 1, it means that a 6-membered ring is formed,

however, at least one atom of $Y^6$ to $Y^{15}$ and Z is an atom including an unshared electron pair, or R bonding thereto includes at least one atom including an unshared electron pair,

<Chemical Formula 2>

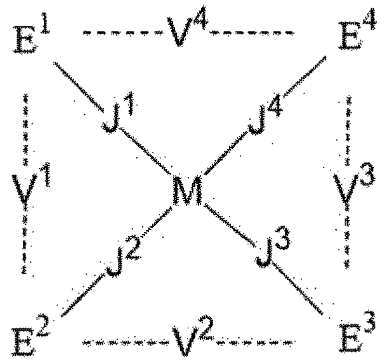

in Chemical Formula 2,

M is a transition metal,

$V^1$, $V^2$, $V^3$ and $V^4$ are each independently not present, or a single bond, $-B(Ar^5)-$, $-C(Ar^5)(Ar^6)-$, $-Si(Ar^5)(Ar^6)-$, $-Ge(Ar^5)(Ar^6)-$, $-N(Ar^5)-$, $-P(Ar^5)-$, $-PO(Ar^5)-$, -O-, -S-, -SO-, $-SO_2-$, -Se-, -SeO-, $-SeO_2-$, -CO-, -CS- or -CSe-, and herein, $Ar^5$ and $Ar^6$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^5$ and $Ar^6$ may be linked to each other to form a ring, or may each be linked to adjacent $E^1$, $E^2$, $E^3$ or $E^4$ to form a fused ring,

however, at least one of $V^1$, $V^2$, $V^3$ and $V^4$ is a single bond,

when $V^1$, $V^2$, $V^3$ and $V^4$ are not present, two of the adjacent $E^1$, $E^2$, $E^3$ and $E^4$ are not directly linked,

when $V^1$, $V^2$, $V^3$ and $V^4$ are a single bond, two of the adjacent $E^1$, $E^2$, $E^3$ and $E^4$ are directly linked by a single bond, and

when $V^1$, $V^2$, $V^3$ and $V^4$ are not a single bond and are present as any one defined as above, they are linked to two of the adjacent $E^1$, $E^2$, $E^3$ and $E^4$ each by a single bond, or two bonds linked to two of the adjacent $E^1$, $E^2$, $E^3$ and $E^4$ may form a conjugated structure together,

$J^1$, $J^2$, $J^3$ and $J^4$ are each a single bond, O or S,

when $J^1$, $J^2$, $J^3$ and $J^4$ are a single bond, any one of $E^1$, $E^2$, $E^3$ and $E^4$ linked thereto directly bonds to M by a coordination bond or a covalent bond,

when $J^1$, $J^2$, $J^3$ and $J^4$ are O or S, the bond with M is a coordination bond or a covalent bond,

$E^1$, $E^2$, $E^3$ and $E^4$ are each independently a monovalent, divalent or trivalent group and defined as below, provided that, when $E^1$, $E^2$, $E^3$ and $E^4$ are a monovalent group, the adjacent two of $V^1$, $V^2$, $V^3$ and $V^4$ are both absent; when $E^1$, $E^2$, $E^3$ and $E^4$ are a divalent group, any one of the adjacent two of $V^1$, $V^2$, $V^3$ and $V^4$ is not present; and when $E^1$, $E^2$, $E^3$ and $E^4$ are a trivalent group, the adjacent two of $V^1$, $V^2$, $V^3$ and $V^4$ are both present,

$E^1$, $E^2$, $E^3$ and $E^4$ are each independently a monovalent group of halogen or cyano, or saturated or unsaturated aliphatic hydrocarbon having 1 to 50 carbon atoms unsubstituted or substituted with an additional substituent; saturated or unsaturated heteroatom-containing aliphatic hydrocarbon having 1 to 50 carbon atoms unsubstituted or substituted with an additional substituent; an aromatic carbon ring having 5 to 50 carbon atoms unsubstituted or substituted with an additional substituent; an aromatic heteroring having 2 to 50 carbon atoms unsubstituted or substituted with an additional substituent; a saturated or unsaturated alicyclic carbon ring having 3 to 50 carbon atoms unsubstituted or substituted with an additional substituent; or a saturated or unsaturated alicyclic heteroring having 2 to 50 carbon atoms unsubstituted or substituted with an additional substituent,

at least two additional substituents included in $E^1$, $E^2$, $E^3$ and $E^4$ may be linked to form a ring,

however, when $J^1$, $J^2$, $J^3$ or $J^4$ is a single bond, the atom at the linking position from the adjacent $E^1$, $E^2$, $E^3$ or $E^4$ to M is carbon, nitrogen, oxygen, sulfur or phosphorous; or when $J^1$, $J^2$, $J^3$ or $J^4$ is O or S, the atom at the linking position from the adjacent $E^1$, $E^2$, $E^3$ or $E^4$ to O or S of $J^1$, $J^2$, $J^3$ or $J^4$ is carbon,

in any one of $E^l$, $E^2$, $E^3$ and $E^4$, the linking position to the adjacent $J^1$, $J^2$, $J^3$ or $J^4$ and the linking position to the adjacent $V^1$, $V^2$, $V^3$ or $V^4$ are adjacent to each other,

in any one of $E^1$, $E^2$, $E^3$ and $E^4$, the linking positions to two of the adjacent $V^1$, $V^2$, $V^3$ and $V^4$ are different from each other,

an atom capable of bonding according to a stoichiometric ratio except for M in Chemical Formula 2 may be the first linking position or the second linking position of A in Chemical Formula 1, provided that, the first linking position and the second linking position are each (i) different from the linking position from any one of $E^1$, $E^2$, $E^3$ and $E^4$ to the adjacent $J^1$, $J^2$, $J^3$, $J^4$ $V^1$, $V^2$, $V^3$ or $V^4$, and (ii) different from the linking position from any one of $V^1$, $V^2$, $V^3$ and $V^4$ to the adjacent $E^1$, $E^2$, $E^3$ or $E^4$,

the first linking position and the second linking position are adjacent to each other, and

the additional substituents may be present in the numbers capable of bonding according to a stoichiometric ratio and are each independently selected from the group consisting of deuterium, halogen, cyano, $-NO_2$, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, alkynyl having 2 to 30 carbon atoms, allyl having 3 to 30 carbon atoms, aryl having 6 to 30 carbon atoms, heteroaryl having 2 to 30 carbon atoms, $-B(R^{201})(R^{202})$, $-C(R^{203})(R^{204})(R^{205})$, $Si(R^{206})(R^{207})(R^{208})$, $-Ge(R^{209})(R^{210})(R^{211})$, $-N(R^{212})(R^{213})$, $-P(R^{214})(R^{215})$, $-PO(R^{216})(R^{217})$, $-O(R^{218})$, $-S(R^{219})$, $-SO(R^{220})$, $-SO_2(R^{221})$, $Se(R^{222})$, $-SeO(R^{223})$, $-SeO_2(R^{224})$ and combinations thereof, and $R^{201}$ to $R^{224}$ are each independently hydrogen, deuterium, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, aryl having 6 to 30 carbon atoms, or heteroaryl having 2 to 30 carbon atoms.

## Advantageous Effects

An organic light-emitting diode including the novel complex light-emitting compound minimizes a decrease in brightness even when driven for a long period of time by increasing luminescence stability of the device.

Specific effects of the present disclosure in addition to the above-described effect will be described together while describing specific details to carry out the present disclosure hereinafter.

## Brief Description of Drawings

FIG. 1 is a graph comparing device properties of Example 1 and Comparative Example 1.

## Best Mode

Hereinafter, embodiments of the present invention will be described in detail with reference to drawings so that those skilled in the art may readily carry out the present invention. The present invention may be embodied in various different forms, and is not limited to the embodiments described herein.

In the present specification, the term "substitution" means that a hydrogen atom bonding to a carbon atom in a compound is substituted with another substituent. The position where substitution occurs means a position at which the hydrogen atom is substituted. The position is not limited as long as it is a position where hydrogen at the position may be substituted with a substituent. When two or more substitutions occur, the two or more substituents may be the same as or different from each other.

In the present specification, the substituent when "substituted" may be, unless otherwise stated, selected from the group consisting of, for example, deuterium, halogen, cyano, $-NO_2$, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, alkynyl having 2 to 30 carbon atoms, allyl having 3 to 30 carbon atoms, aryl having 6 to 30 carbon atoms, heteroaryl having 2 to 30 carbon atoms, $-B(R^{201})(R^{202})$, $-C(R^{203})(R^{204})(R^{205})$, $Si(R^{206})(R^{207})(R^{208})$, $-Ge(R^{209})(R^{210})(R^{211})$, $-N(R^{212})(R^{213})$, $-P(R^{214})(R^{215})$, $-PO(R^{216})(R^{217})$, $-O(R^{218})$, $-S(R^{219})$, $-SO(R^{220})$, $-SO_2(R^{221})$, $Se(R^{222})$, $-SeO(R^{223})$, $-SeO_2(R^{224})$ and combinations thereof, and $R^{201}$ to $R^{224}$ may be each independently one selected from the group consisting of hydrogen, deuterium, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, aryl having 6 to 30 carbon atoms, heteroaryl having 2 to 30 carbon atoms and combinations thereof, but are not limited thereto.

"Combinations thereof" in the definition of substituents of the present specification means that, unless otherwise defined, two or more substituents are present, or two or more divalent substituents are linked or fused for bonding.

In the present specification, a case of two substituents being linked to form a ring includes a case in which one of the two substituents is hydrogen, and the two substituents are linked as the hydrogen is removed.

In the present specification, unless otherwise stated, "alkyl" includes linear or branched forms, and, unless otherwise stated, is a collective name that includes "cycloalkyl and heterocycloalkyl". In the present specification, unless otherwise stated, "alkenyl" includes linear or branched forms, and, unless otherwise stated, is a collective name that includes "cycloalkenyl and heterocycloalkenyl". For example, unless otherwise stated, alkylamine is a collective name that includes cycloalkylamine and heterocycloalkylamine.

In the present specification, "heteroalkyl" or "heteroalkylene" refers to a case in which at least one carbon atom in alkyl or alkylene is substituted with a heteroatom, and the number of carbon atoms thereof means the number of carbon atoms excluding the heteroatom.

In the present specification, "heteroalkenyl" refers to a case in which at least one carbon atom that does not form a double bond in alkenyl is substituted with a heteroatom, and the number of carbon atoms thereof means the number of carbon atoms excluding the heteroatom.

In the present specification, "heterocycloalkyl" refers to a case in which at least one carbon atom in cycloalkyl is substituted with a heteroatom, and the number of carbon atoms thereof means the number of carbon atoms excluding the heteroatom.

In the present specification, "heterocycloalkenyl" refers to a case in which at least one carbon atom that does not form a double bond in cycloalkenyl is substituted with a heteroatom, and the number of carbon atoms thereof means the number of carbon atoms excluding the heteroatom.

In the present specification, "hetero" means, unless otherwise defined, including a heteroatom in one compound or substituent. The heteroatom means an atom that is not carbon and hydrogen. Examples thereof may include N, O, Si, Ge, S, P, B, Se, Te and the like, but are not limited thereto. When two or more heteroatoms are included in one compound or substituent, the included heteroatoms may be the same as or different from each other, and, for example, be one, or two or more types of heteroatoms. For example, heteroaryl or heterocycloalkyl includes at least one heteroatom as an atom forming the ring.

In the present specification, "aryl", "arylene" or "aromatic" may be a monocyclic ring or a polycyclic ring according to a commonly known definition, and includes a conjugated structure in a part or all thereof. The polycyclic ring may be a fused ring or a linked form, and for example, aryl or aromatic carbon ring includes biphenyl.

Substituents other than the substituents defined as above as substituents mentioned in the present specification

follow known definitions of substituents.

In the present specification, when substituents or linking positions are adjacent in chemical formulae, it means a case in which atoms to which the substituents are linked or atoms of the linking positions are directly linked.

In the present specification, when a definition of a substituent includes a case of being substituted with an additional substituent, the additional substituent belongs to the category of the defined substituent, unless otherwise stated. For example, when Z of Chemical Formula 1 is -N($Ar^1$)-and $Ar^1$ is phenyl substituted with methyl as an additional substituent, methyl as the additional substituent belongs to Z. In other words, the category of Z herein includes methyl that is an additional substituent. Z is described as an example herein, however, for all substituents defined in chemical formulae in the present specification, it needs to be understood that, when it is possible to be substituted with an additional substituent, the additional substituent is included in the category of the defined substituent. As another example, the first linking position or the second linking position of A in Chemical Formula 1 may be positioned at an additional substituent defined to be within the category of A, and similarly, the linking position of $E^1$ or the like in Chemical Formula 2 may be positioned at an additional substituent that belongs to the category of $E^1$.

In the present specification, the number of substitutions with additional substituents may be the number capable of bonding according to a stoichiometric ratio unless otherwise stated.

In the present specification, a ring includes a fused ring unless otherwise stated.

In the present specification, when two entities (substituents and the like) are linked, it includes a case in which any one of the entities is hydrogen, and the entities are linked as the hydrogen is eliminated.

In the present specification, unless otherwise stated, a dotted line in a chemical structural formula represents that it may or may not be present.

In the present specification, both a coordination bond and a single bond in a chemical structural formula are expressed as a straight line and not distinguished, however, all structures capable of bonding according to a stoichiometric ratio are included.

One embodiment of the present invention provides,

an organic light-emitting diode including: a first electrode; a second electrode; and a light-emitting layer interposed between the first electrode and the second electrode,

wherein the light-emitting layer includes a complex light-emitting compound represented by the following Chemical Formula 1,

the complex light-emitting compound includes a light-emitting moiety and a charge-stabilizing moiety, the light-emitting moiety and the charge-stabilizing moiety are linked through atom X, and atom X is X presented in the following Chemical Formula 1,

the light-emitting moiety includes A, a conjugated ring formed to include $Y^1$ to $Y^5$, and Q in the following Chemical Formula 1,

the charge-stabilizing moiety includes a ring formed to include $Y^6$ to $Y^{10}$, a ring formed to include $Y^{11}$ to $Y^{15}$, and Z in the following Chemical Formula 1, and

the charge-stabilizing moiety includes at least one atom having an unshared electron pair.

<Chemical Formula 1>

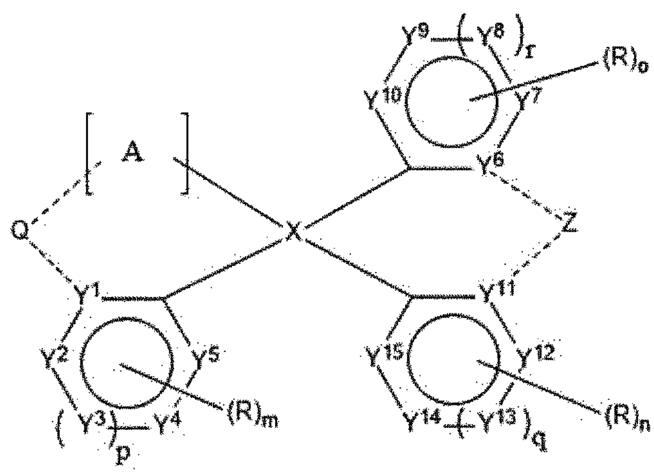

In Chemical Formula 1,

A is a structure represented by the following Chemical Formula 2, and is linked through a first linking position of A, or linked through a first linking position and a second linking position of A,

X is C, Si, Ge, Sn or Pb, and the first linking position of A is linked to X,

Q is not present, or a single bond, -B($Ar^1$)-, - C($Ar^1$)($Ar^2$)-, -Si($Ar^1$)($Ar^2$)-, -Ge($Ar^1$)($Ar^2$)-, -N($Ar^1$)-, - P($Ar^1$)-, -PO($Ar^1$)-, -O-, -S-, -SO-, -$SO_2$-, -Se-, -SeO-, -$SeO_2$-, -CO-, -CS- or -CSe-, and herein, $Ar^1$ and $Ar^2$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^1$ and $Ar^2$ may be linked to each other to form a ring, or may each be linked to $Y^2$, R that is linked to $Y^2$, or A to form a fused ring,

when Q is not present, A is not directly linked to $Y^1$ at the second linking position of A,

when Q is a single bond, A is linked to $Y^1$ by a single bond at the second linking position of A,

when Q is not a single bond and is present as any one defined as above, A is linked to Q at the second linking position of A,

when Q is not a single bond and is present as any one defined as above, Q is linked to A and $Y^1$ each by a single bond,

$Y^1$ to $Y^{15}$ are each independently boron, carbon, nitrogen, oxygen, sulfur, Se or Te,

Z is not present, or a single bond, -B($Ar^3$)-, - C($Ar^3$)($Ar^4$)-, -Si($Ar^3$)($Ar^4$)-, -Ge($Ar^3$)($Ar^4$)-, -N($Ar^3$)-, - P($Ar^4$)-, -PO($Ar^3$)-, -O-, -S-, -SO-, -$SO_2$-, -Se-, -SeO-, -$SeO_2$-, -CO-, -CS- or -CSe-, and herein, $Ar^3$ and $Ar^4$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^3$ and $Ar^4$ may be linked to each other to form a ring, or may each be linked to any one of $Y^7$, $Y^{12}$, R that is linked to $Y^7$ or R that is linked to $Y^{12}$ to form a fused ring,

when Z is not present, $Y^6$ and $Y^{11}$ are not directly linked,

when Z is a single bond, $Y^6$ and $Y^{11}$ are linked by a single bond,

when Z is not a single bond and is present as any one defined as above, Z is linked to $Y^6$ and $Y^{11}$ each by a single bond,

m, n and o are each independently an integer of 0 to 5,

Rs are each independently at least one selected from the group consisting of hydrogen, deuterium, halogen, cyano, -$NO_2$, alkyl having 1 to 30 carbon atoms unsubstituted or substituted with an additional substituent, alkenyl having 2 to 30 carbon atoms unsubstituted or substituted with an additional substituent, alkynyl having 2 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heteroalkenyl having 2 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent,

allyl having 3 to 30 carbon atoms unsubstituted or substituted with an additional substituent, aryl having 6 to 30 carbon atoms unsubstituted or substituted with an additional substituent, heteroaryl having 2 to 30 carbon atoms unsubstituted or substituted with an additional substituent, -B($R^{101}$)($R^{102}$), -C($R^{103}$)($R^{104}$)($R^{105}$), - Si($R^{106}$)($R^{107}$)($R^{108}$), -Ge($R^{109}$)($R^{110}$)($R^{111}$), -N($R^{112}$)($R^{113}$), - P($R^{114}$)($R^{115}$), -PO($R^{116}$)($R^{117}$), -O($R^{118}$), -S($R^{119}$), -SO($R^{120}$), - $SO_2$($R^{121}$), Se($R^{122}$), -SeO($R^{123}$), -$SeO_2$($R^{124}$) and combinations thereof,

$R^{101}$ to $R^{124}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and at least two of $R^{101}$ to $R^{124}$ linked to one atom may be linked to form a ring,

at least two Rs present when m, n or o is 2 or greater may be linked to each other to form a ring,
p, q and r each independently represent 0 or 1, and when p, q or r is 0, it means that a 5-membered ring is formed, and when p, q or r is 1, it means that a 6-membered ring is formed,
however, at least one atom of $Y^6$ to $Y^{15}$ and Z is an atom including an unshared electron pair, or R bonding thereto includes at least one atom including an unshared electron pair,

<Chemical Formula 2>

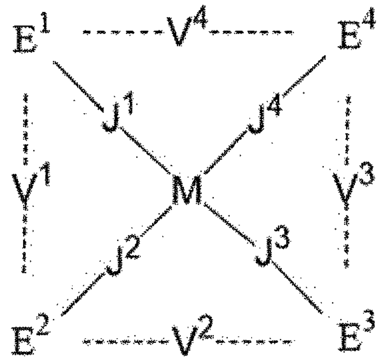

in Chemical Formula 2,
M is a transition metal,
$V^1$, $V^2$, $V^3$ and $V^4$ are each independently not present, or a single bond, $-B(Ar^5)-$, $-C(Ar^5)(Ar^6)-$, $-Si(Ar^5)(Ar^6)-$, $-Ge(Ar^5)(Ar^6)-$, $-N(Ar^5)-$, $-P(Ar^5)-$, $-PO(Ar^5)-$, -O-, -S-, -SO-, $-SO_2-$, -Se-, -SeO-, $-SeO_2-$, -CO-, -CS- or - CSe-, and herein, $Ar^5$ and $Ar^6$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^5$ and $Ar^6$ may be linked to each other to form a ring, or may each be linked to adjacent $E^1$, $E^2$, $E^3$ or $E^4$ to form a fused ring,
however, at least one of $V^1$, $V^2$, $V^3$ and $V^4$ is a single bond,
when $V^1$, $V^2$, $V^3$ and $V^4$ are not present, two of the adjacent $E^1$, $E^2$, $E^3$ and $E^4$ are not directly linked,
when $V^1$, $V^2$, $V^3$ and $V^4$ are a single bond, two of the adjacent $E^1$, $E^2$, $E^3$ and $E^4$ are directly linked by a single bond, and when $V^1$, $V^2$, $V^3$ and $V^4$ are not a single bond and are present as any one defined as above, they are linked to two of the adjacent $E^1$, $E^2$, $E^3$ and $E^4$ each by a single bond, or two bonds linked to two of the adjacent $E^1$, $E^2$, $E^3$ and $E^4$ may form a conjugated structure together,
$J^1$, $J^2$, $J^3$ and $J^4$ are each a single bond, O or S,
when $J^1$, $J^2$, $J^3$ and $J^4$ are a single bond, any one of $E^1$, $E^2$, $E^3$ and $E^4$ linked thereto directly bonds to M by a coordination bond or a covalent bond,
when $J^1$, $J^2$, $J^3$ and $J^4$ are O or S, the bond with M is a coordination bond or a covalent bond,
$E^1$, $E^2$, $E^3$ and $E^4$ are each independently a monovalent, divalent or trivalent group and defined as below, provided that, when $E^1$, $E^2$, $E^3$ and $E^4$ are a monovalent group, the adjacent two of $V^1$, $V^2$, $V^3$ and $V^4$ are both absent; when $E^1$, $E^2$, $E^3$ and $E^4$ are a divalent group, any one of the adjacent two of $V^1$, $V^2$, $V^3$ and $V^4$ is not present; and when $E^1$, $E^2$, $E^3$ and $E^4$ are a trivalent group, the adjacent two of $V^1$, $V^2$, $V^3$ and $V^4$ are both present,
$E^1$, $E^2$, $E^3$ and $E^4$ are each independently a monovalent group of halogen or cyano, or saturated or unsaturated aliphatic hydrocarbon having 1 to 50 carbon atoms unsubstituted or substituted with an additional substituent; saturated or unsaturated heteroatom-containing aliphatic hydrocarbon having 1 to 50 carbon atoms unsubstituted or substituted with an additional substituent; an aromatic carbon ring having 5 to 50 carbon atoms unsubstituted or substituted with an additional substituent; an aromatic heteroring having 2 to 50 carbon atoms unsubstituted or substituted with an additional substituent; a saturated or unsaturated alicyclic carbon ring having 3 to 50 carbon atoms unsubstituted or substituted with an additional substituent; or a saturated or unsaturated alicyclic heteroring having 2

to 50 carbon atoms unsubstituted or substituted with an additional substituent,

at least two additional substituents included in $E^1$, $E^2$, $E^3$ and $E^4$ may be linked to form a ring,

however, when $J^1$, $J^2$, $J^3$ or $J^4$ is a single bond, the atom at the linking position from the adjacent $E^1$, $E^2$, $E^3$ or $E^4$ to M is carbon, nitrogen, oxygen, sulfur or phosphorous; or when $J^1$, $J^2$, $J^3$ or $J^4$ is O or S, the atom at the linking position from the adjacent $E^1$, $E^2$, $E^3$ or $E^4$ to O or S of $J^1$, $J^2$, $J^3$ or $J^4$ is carbon,

in any one of $E^1$, $E^2$, $E^3$ and $E^4$, the linking position to the adjacent $J^1$, $J^2$, $J^3$ or $J^4$ and the linking position to the adjacent $V^1$, $V^2$, $V^3$ or $V^4$ are adjacent to each other,

in any one of $E^1$, $E^2$, $E^3$ and $E^4$, the linking positions to two of the adjacent $V^1$, $V^2$, $V^3$ and $V^4$ are different from each other,

an atom capable of bonding according to a stoichiometric ratio except for M in Chemical Formula 2 may be the first linking position or the second linking position of A in Chemical Formula 1, provided that, the first linking position and the second linking position are each (i) different from the linking position from any one of $E^1$, $E^2$, $E^3$ and $E^4$ to the adjacent $J^1$, $J^2$, $J^3$, $J^4$ $V^1$, $V^2$, $V^3$ or $V^4$, and (ii) different from the linking position from any one of $V^1$, $V^2$, $V^3$ and $V^4$ to the adjacent $E^1$, $E^2$, $E^3$ or $E^4$,

the first linking position and the second linking position are adjacent to each other, and

the additional substituents may be present in the numbers capable of bonding according to a stoichiometric ratio and are each independently selected from the group consisting of deuterium, halogen, cyano, $-NO_2$, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, alkynyl having 2 to 30 carbon atoms, allyl having 3 to 30 carbon atoms, aryl having 6 to 30 carbon atoms, heteroaryl having 2 to 30 carbon atoms, $-B(R^{201})(R^{202})$, $-C(R^{203})(R^{204})(R^{205})$, $Si(R^{206})(R^{207})(R^{208})$, $-Ge(R^{209})(R^{210})(R^{211})$, $-N(R^{212})(R^{213})$, $-P(R^{214})(R^{215})$, $-PO(R^{216})(R^{217})$, $-O(R^{218})$, $-S(R^{219})$, , $-SO(R^{220})$, $-SO_2(R^{221})$, $Se(R^{222})$, $-SeO(R^{221})$, $-SeO_2(R^{224})$ and combinations thereof, and $R^{201}$ to $R^{224}$ are each independently hydrogen, deuterium, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, aryl having 6 to 30 carbon atoms, or heteroaryl having 2 to 30 carbon atoms.

In the definition of Chemical Formula 1, when $Ar^1$ or $Ar^2$ that is not hydrogen and deuterium of Q is linked to $Y^2$ or R that is linked to $Y^2$ to form a fused ring, it includes a case in which R that is linked to $Y^2$ is hydrogen, and as R, the hydrogen, is eliminated, $Ar^1$ or $Ar^2$ is linked to $Y^2$.

In the definition of Chemical Formula 1, when $Ar^3$ or $Ar^4$ of Z is linked to any one of $Y^7$, $Y^{12}$, R that is linked to $Y^7$ and R that is linked to $Y^{12}$ to form a fused ring, it includes a case in which R that is linked to $Y^7$ or R that is linked to $Y^{12}$ is hydrogen, and as R, the hydrogen, is eliminated, $Ar^3$ or $Ar^4$ is linked to $Y^7$ or $Y^{12}$.

When at least two Rs are linked to form a ring in Chemical Formula 1, such a ring includes a fused ring. In addition, when two Rs are linked, it includes a case in which any one R of the linked two Rs is hydrogen, and as R, the hydrogen, is eliminated, the other R of the two Rs is directly linked to any one of $Y^1$ to $Y^{15}$ to which R, the hydrogen, is linked.

In Chemical Formula 2, when at least two additional substituents included in $E^1$, $E^2$, $E^3$ and $E^4$ are linked to form a ring, such a ring includes a fused ring. The two additional substituents forming such a ring may be additional substituents each linked to any one or two of $E^1$, $E^2$, $E^3$ and $E^4$. In addition, when two additional substituents are linked, it includes case in which any one of the linked two is hydrogen, and these are linked as the hydrogen is eliminated.

In the definition of Chemical Formula 2, the atom at the linking position linked to $J^1$, $J^2$, $J^3$, $J^4$ or M in $E^1$, $E^2$, $E^3$ and $E^4$ may be an atom included in aliphatic hydrocarbon, heteroatom-containing aliphatic hydrocarbon, an aromatic carbon ring, an aromatic heteroring, an alicyclic carbon ring or an alicyclic heteroring defined for $E^1$, $E^2$, $E^3$ and $E^4$, or an atom included in additional substituents linked thereto.

By the organic light-emitting diode using the novel complex light-emitting compound represented by Chemical Formula 1, an organic light-emitting diode that minimizes a decrease in brightness even when driven for a long period of time is obtained by increasing luminescence stability of the device.

A dopant generally performs a decisive role in, in addition to emission wavelength and efficiency of an organic light-emitting diode, a property of decrease in brightness depending on driving time of the device. The complex light-emitting compound has been developed to exhibit stable brightness even when driving the device for a long period of time by improving a deterioration mechanism and an energy transfer process of the dopant.

A process in which electrons and holes injected into a light-emitting layer combine in a host of the light-emitting layer to form excitons and the energy is transferred to a dopant is explained with a method by light of the following Mathematical Formula 1 (FRET, Forster Resonance Energy transfer) and a method by electron of the following Mathematical Formula 2 (Dexter Electron Transfer).

FRET (Forster Resonance Energy transfer)

[Mathematical Formula 1]

$$k_{ET} = (\frac{1}{r^6 \tau_D})(\frac{2.07\kappa^2 Q_D J}{128\pi^5 N_A n^4})$$

Dexter Electron Transfer

[Mathematical Formula 2]

$$k_{ET} \propto J exp^{(-\frac{2r}{L})}$$

$k_{ET}$: rate constant
r: distance between energy donor and energy acceptor
$\tau_d$: PL decay time of energy donor
$\kappa$: orientation factor
$Q_D$: PL quantum efficiency of energy donor
$N_A$: Avogadro number
n: refractive index
J: defined by Mathematical Formula 3.

[Mathematical Formula 3]

$$J = \int f_D(\lambda)\varepsilon_A(\lambda)\lambda^4 d\lambda$$

$f_D$: emission spectrum of energy donor
$\varepsilon_A$: extinction coefficient depending on wavelength of energy acceptor
L: sum of Van der Waals radii
$\lambda$: wavelength

Once the dopant receives energy from the host, it becomes excited. In other words, this state is the same as a state in which one of the two electrons present at the HOMO (Highest Occupied Molecular Orbital) level of the dopant moves to the LUMO (Lowest Unoccupied Molecular Orbital) level. It takes from several nanoseconds to several milliseconds, varying depending on the spin state of the electron, for the electron at the LUMO level to come down to the HOMO level and stabilize again. Considering that the time taken for vibratory motion of a molecule is on the order of few picoseconds, the dopant in an excited state continuously interacts with surrounding molecules before being relaxed by light. The dopant creates new energy levels, produces chemical reactions, or is decomposed, and such a series of processes accelerate a decrease in the luminescence intensity depending on the driving time of an organic light-emitting diode.

The HOMO-LUMO gap energy of a dopant is always smaller than the HOMO-LUMO gap energy of a host material, however, the positions of energy levels between the two materials are not always constant, and may appear in two forms shown in the image below. In the image below, $E_{HOMO}$ represents the HOMO energy level of each material, and $E_{LUMO}$ represents the LUMO energy level of each material.

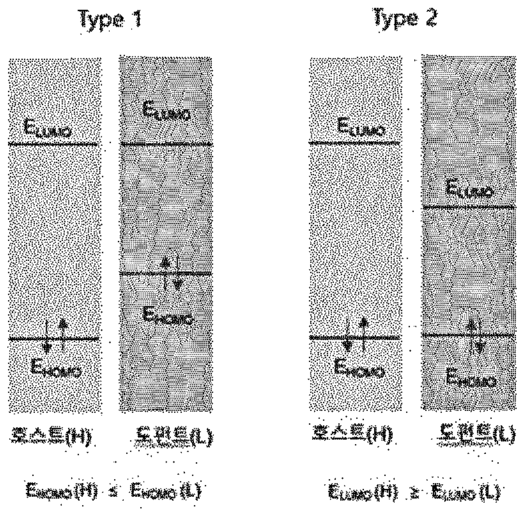


호스트(H): Host (H)
도펀트(L): Dopant (L)

Type 1 is a case in which the HOMO energy level of a dopant is higher than the HOMO energy level of a host, and Type 2 is a case in which the LUMO energy level of a dopant is lower than the LUMO energy level of a host. Holes are directly injected into a light-emitting layer through a hole transport layer, and electrons are injected into the light-emitting layer through an electron transport layer from the opposite side. Since holes and electrons are injected from opposite sides of the light-emitting layer having a thickness of 200 Å to 500 Å, the holes are trapped (Type 1) or the electrons are trapped (Type 2) in the dopant before the two charges meet to form excitons.

When charges are trapped in the dopant, the ionized dopant is very unstable until opposite charges arrive, and the ionized dopant seeks a way to stabilize. The ionized dopant interacts with other surrounding excitons formed previously, produces chemical reactions with surrounding compounds, or is decomposed. Such a series of processes accelerate a decrease in luminescence intensity depending on driving time of an organic light-emitting device.

The novel complex light-emitting compound represented by Chemical Formula 1 is capable of maintaining stable brightness of an organic light-emitting device even when driving the organic light-emitting device for a long period of time since the charge-stabilizing moiety stabilizes the light-emitting moiety at a very close distance when the complex light-emitting compound is present in an excited state or ionized state.

The light-emitting moiety and the charge-stabilizing moiety of the complex light-emitting compound are as defined in Chemical Formula 1.

Specifically, the charge-stabilizing moiety includes a conjugated ring formed to include $Y^6$ to $Y^{10}$, a conjugated ring formed to include $Y^{11}$ to $Y^{15}$, and Z in Chemical Formula 1.

The first role of the charge-stabilizing moiety is to stabilize the light-emitting moiety when the light-emitting moiety is ionized by trapping charges or in an excited state.

The second role of the charge-stabilizing moiety is to reduce the probability that the light-emitting moiety in an excited state or ionized state interacts with surrounding other molecules by spatially protecting a certain portion of the light-emitting moiety.

The third role of the charge-stabilizing moiety is to reduce the probability that charges are directly trapped in the light-emitting moiety by spatially protecting a certain portion of the light-emitting moiety.

The charge-stabilizing moiety has polarity (dipole moment) to perform these roles. Specifically, the charge-stabilizing moiety includes at least one atom having an unshared electron pair, and has polarity of greater than 0 Debye.

Examples of the atom having an unshared electron pair may include nitrogen, phosphorous, arsenic, antimony, oxygen, sulfur, Se, fluorine, chlorine, bromine and the like. The atom having an unshared electron pair included in the charge-stabilizing moiety may perform a role of an electron donor or an electron acceptor depending on the bonding manner, or may stabilize the light-emitting moiety by allowing the charge-stabilizing moiety to have polarity. In addition, the atom including an unshared electron pair needs to constitute a wave function of HOMO or LUMO. In other words, the atom needs to be included in a wave function representing electron distribution of HOMO and LUMO. For example, in the HOMO wave function of the charge-stabilizing moiety, forming high electron density in the atom having an unshared electron pair increases the stabilization effect when the light-emitting moiety has a positive charge. On the other hand, in the LUMO wave function of the charge-stabilizing moiety, when high electron density is formed in the atom having an unshared electron pair, a stabilization effect can be expected when the light-emitting moiety has a negative charge. Quantum

calculation may be performed using DFT B3LYP 6-31G* as a basis set. The criterion for defining the HOMO and LUMO wave functions of the charge-stabilizing moiety is obtained by calculation using DFT based on a structure in which the linkage between the light-emitting moiety and X is broken and the linking site is substituted with hydrogen or $-CH_3$.

In one embodiment, in Chemical Formula 1,

(i) at least one of $Y^6$ to $Y^{15}$; and atoms of Z linked to $Y^6$ and $Y^{11}$ is an atom having an unshared electron pair included in a wave function of HOMO or LUMO of the charge-stabilizing moiety; or

(ii) at least one of $Y^6$ to $Y^{15}$ has R represented by the following Chemical Formula 9 or the following Chemical Formula 10.

<Chemical Formula 9>

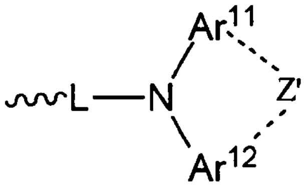

<Chemical Formula 10>

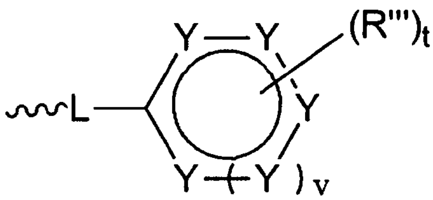

In Chemical Formula 9 and Chemical Formula 10,

L is a single bond, or a divalent group selected from the group consisting of alkylene having 1 to 20 carbon atoms, cycloalkylene having 3 to 20 carbon atoms, cycloalkenylene having 3 to 20 carbon atoms, heteroalkylene having 1 to 20 carbon atoms, heterocycloalkylene having 2 to 20 carbon atoms, heterocycloalkenylene having 2 to 20 carbon atoms, alkenylene having 2 to 20 carbon atoms, -O-, -S-, - $P(R^{401})$-, $-PO(R^{402})$-, arylene having 6 to 20 carbon atoms, heteroarylene having 5 to 20 carbon atoms and combinations thereof,

$Ar^{11}$ and $Ar^{12}$ are each independently a monovalent group or a divalent group of saturated or unsaturated aliphatic hydrocarbon having 1 to 20 carbon atoms unsubstituted or substituted with an additional substituent; saturated or unsaturated heteroatom-containing aliphatic hydrocarbon having 1 to 20 carbon atoms unsubstituted or substituted with an additional substituent; an aromatic carbon ring having 5 to 20 carbon atoms unsubstituted or substituted with an additional substituent; an aromatic heteroring having 2 to 20 carbon atoms unsubstituted or substituted with an additional substituent; a saturated or unsaturated alicyclic carbon ring having 3 to 20 carbon atoms unsubstituted or substituted with an additional substituent; or a saturated or unsaturated alicyclic heteroring having 2 to 20 carbon atoms unsubstituted or substituted with an additional substituent,

Z' is not present, or a single bond, $-B(Ar^{13})$-, - $C(Ar^{13})(Ar^{14})$-, $-Si(Ar^{13})(Ar^{14})$-, $-Ge(Ar^{13})(Ar^{14})$-, $-N(Ar^{13})$-, - $P(Ar^{13})$-, $-PO(Ar^{13})$-, -O-, -S-, -SO-, $-SO_2$-, -Se-, -SeO-, - $SeO_2$-, -CO-, -CS- or -CSe-, and herein, $Ar^{13}$ and $Ar^{14}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^{13}$ and $Ar^{14}$ may be linked to each other to form a ring, or may each be linked to any one of $Ar^{11}$ and $Ar^{12}$ to form a fused ring,

when Z' is not present, $Ar^{11}$ and $Ar^{12}$ are not directly linked,

when Z' is a single bond, $Ar^{11}$ and $Ar^{12}$ are linked by a single bond,

t is an integer of 0 to 5,

v is 0 or 1,
R'"s are each independently at least one selected from the group consisting of hydrogen, deuterium, halogen, cyano, $-NO_2$, alkyl having 1 to 30 carbon atoms, heteroalkyl having 1 to 30 carbon atoms, cycloalkyl having 3 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, alkynyl having 2 to 30 carbon atoms, allyl having 3 to 30 carbon atoms, aryl having 6 to 30 carbon atoms, heteroaryl having 2 to 30 carbon atoms, $-B(R^{501})(R^{502})$, $-C(R^{503})(R^{504})(R^{505})$, $-Si(R^{506})(R^{507})(R^{508})$, $-Ge(R^{509})(R^{510})(R^{511})$, $-N(R^{512})(R^{513})$, $-P(R^{514})(R^{515})$, $-PO(R^{516})(R^{517})$, $-O(R^{518})$, $-S(R^{519})$, $-SO(R^{520})$, $-SO_2(R^{521})$, $Se(R^{522})$, $-SeO(R^{523})$, $-SeO_2(R^{524})$ and combinations thereof, and herein, at least two R‴s may be linked to each other to form a ring,
$R^{401}$ to $R^{402}$ and $R^{501}$ to $R^{524}$ are each independently hydrogen, deuterium, halogen, alkyl having 1 to 30 carbon atoms, cycloalkyl having 3 to 30 carbon atoms, heteroalkyl having 1 to 30 carbon atoms, heterocycloalkyl having 2 to 30 carbon atoms, aryl having 6 to 30 carbon atoms, or heteroaryl having 2 to 30 carbon atoms, and at least two of $R^{401}$ to $R^{402}$ and $R^{501}$ to $R^{524}$ linked to one atom may be linked to form a ring,
Ys are each independently nitrogen, oxygen, sulfur or carbon,

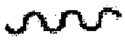

represents a linking site,
the additional substituents may be present in the numbers capable of bonding according to a stoichiometric ratio and are each independently selected from the group consisting of deuterium, halogen, cyano, $-NO_2$, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, alkynyl having 2 to 30 carbon atoms, allyl having 3 to 30 carbon atoms, aryl having 6 to 30 carbon atoms, heteroaryl having 2 to 30 carbon atoms, $-B(R^{201})(R^{202})$, $-C(R^{203})(R^{204})(R^{205})$, $Si(R^{206})(R^{207})(R^{208})$, $-Ge(R^{209})(R^{210})(R^{211})$, $-N(R^{212})(R^{213})$, $-P(R^{214})(R^{215})$, $-PO(R^{216})(R^{217})$, $-O(R^{218})$, $-S(R^{219})$, $-SO(R^{220})$, $-SO_2(R^{221})$, $Se(R^{222})$, $-SeO(R^{223})$, $-SeO_2(R^{224})$ and combinations thereof, and $R^{201}$ to $R^{224}$ are each independently hydrogen, deuterium, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, aryl having 6 to 30 carbon atoms, or heteroaryl having 2 to 30 carbon atoms,
however, in Chemical Formula 10, L or R'" includes at least one atom having an unshared electron pair included in a wave function of HOMO or LUMO of the charge-stabilizing moiety, or at least one of Ys is nitrogen, oxygen or sulfur.

When at least two R'"s are linked to form a ring in Chemical Formula 10, such a ring includes a fused ring. In addition, when two R‴s are linked, it includes a case in which any one R'" of the linked two is hydrogen, and as R‴, the hydrogen, is eliminated, the other R‴ is directly linked to Y to which R‴, the hydrogen, is linked.

In one embodiment, at least one R included in Chemical Formula 1 may be represented by any one of structures of the following Chemical Formulae D-1 to D-38.

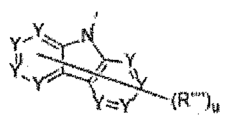

D-1

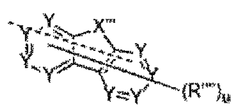

D-2

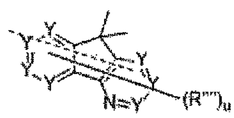

D-3

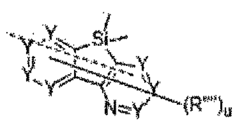

D-4

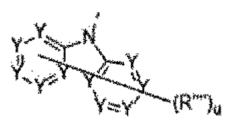

D-5

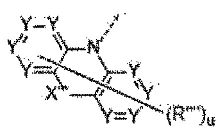
D-6

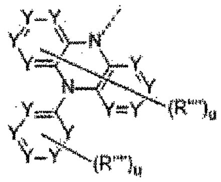
D-7

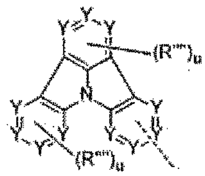
D-8

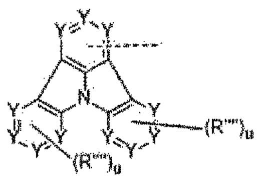
D-9

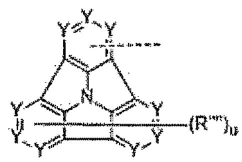
D-10

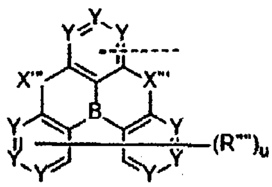
D-11

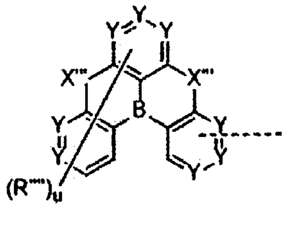
D-12

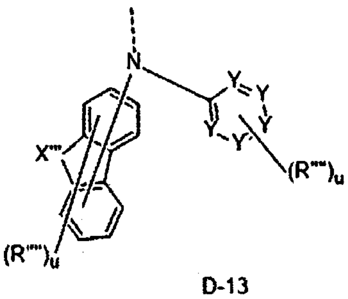
D-13

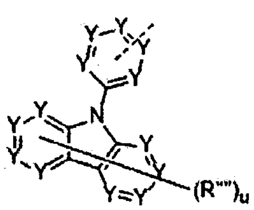
D-14

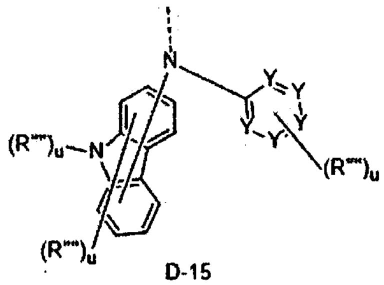
D-15

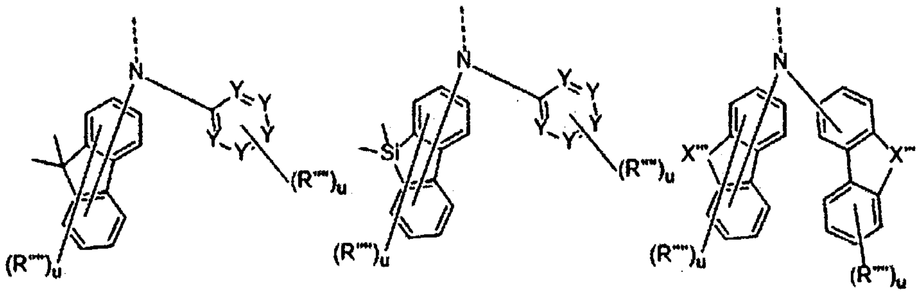
D-16 D-17 D-18

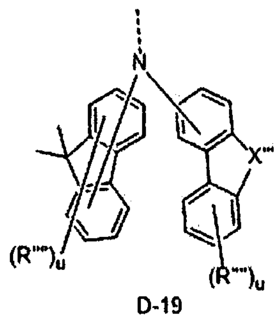 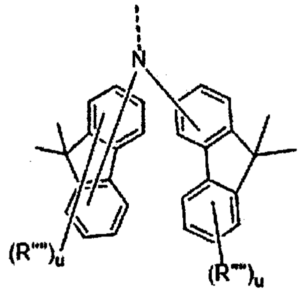

D-19 D-20

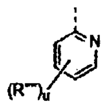 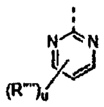 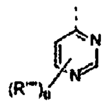

D-21 D-22 D-23

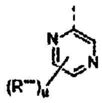 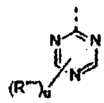

D-24 D-25

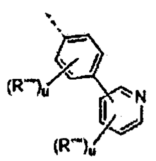 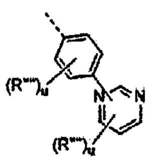 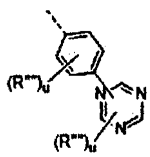

D-26 D-27 D-28

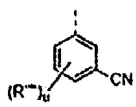 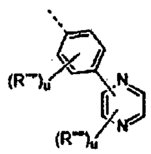

D-29 D-30

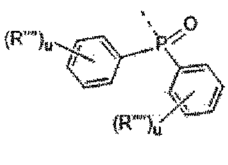 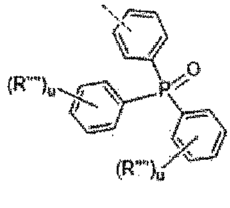 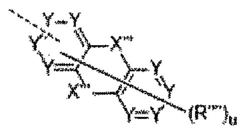

D-31 D-32 D-33

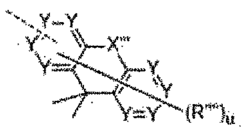 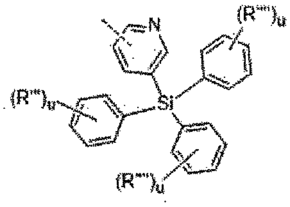

D-34 D-35

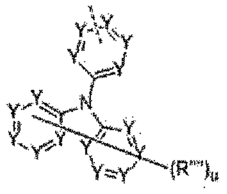 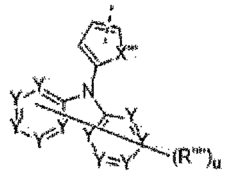 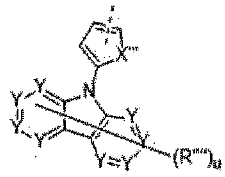

D-36 D-37 D-38

In Chemical Formulae D-1 to D-38,

Ys are each independently carbon or nitrogen,
X'''s are each independently oxygen, nitrogen, sulfur or selenium,
R''''s are each independently selected from the group consisting of hydrogen, deuterium, halogen, cyano, - $NO_2$, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, alkynyl having 2 to 30 carbon atoms, allyl having 3 to 30 carbon atoms, aryl having 6 to 30 carbon atoms, heteroaryl having 2 to 30 carbon atoms, -B($R^{601}$)($R^{602}$), -C($R^{603}$)($R^{604}$)($R^{605}$), - Si($R^{606}$)($R^{607}$)($R^{608}$), -Ge($R^{609}$)($R^{610}$)($R^{611}$), -N($R^{612}$)($R^{613}$), - P($R^{614}$)($R^{615}$), -PO($R^{616}$)($R^{617}$), -O($R^{618}$), -S($R^{619}$), -SO($R^{620}$), - $SO_2$($R^{621}$), Se($R^{622}$), -SeO($R^{623}$), -$SeO_2$($R^{624}$) and combinations thereof, and $R^{601}$ to $R^{624}$ are each independently selected from hydrogen, deuterium, alkyl having 1 to 30 carbon atoms, cycloalkyl having 3 to 30 carbon atoms, heterocycloalkyl having 2 to 30 carbon atoms, aryl having 6 to 30 carbon atoms, heteroaryl having 2 to 30 carbon atoms and combinations thereof,
us are each independently an integer of 0 to 20, and
the dotted line represents a linking site.

In the complex light-emitting compound represented by Chemical Formula 1, the charge-stabilizing moiety and the light-emitting moiety bond by atom X, and when Z is present, a spiro bond is formed by spiro atom X.

The first role of the linking portion by atom X is to ensure that the charge-stabilizing moiety and the light-emitting moiety exist at a certain distance and space. When the charge-stabilizing moiety maintains a spatial position and angle that do not cause chemical interaction with the light-emitting moiety in this way, there is an advantage of significantly reducing the probability of chemical interaction and Coulomb interaction with surrounding other dopant materials, host materials and excitons by protecting a certain portion of the light-emitting moiety.

The second role of the linking portion by atom X is to spatially minimize the HOMO or LUMO wave function overlap between the charge-stabilizing moiety and the light-emitting moiety. This is due to the fact that, when a significant wave function overlap occurs by the overlap of conjugated structures of the charge-stabilizing moiety and the light-emitting moiety, it may cause a problem of shifting an emission wavelength of the light-emitting moiety to a long wavelength, or reducing luminous efficiency.

The linking portion by atom X may be formed by linking the charge-stabilizing moiety and the light-emitting moiety through a spiro bond, or may be a linking group. When the linking portion by atom X is formed as a linking group, Q or Z is not present in Chemical Formula 1, and a spiro bond is not formed.

Specifically, the light-emitting moiety includes A, a conjugated ring formed to include $Y^1$ to $Y^5$, and Q in Chemical Formula 1.

The light-emitting moiety may be induced from a light-emitting material (referred to as light-emitting compound in the present specification) capable of emitting light by electron migration in an organic light-emitting diode.

The light-emitting compound (light-emitting material) may be a compound that may be commonly used as a dopant in an organic light-emitting diode. A dopant capable of implementing a desired color is selected as the light-emitting compound depending on the purpose, and the light-emitting moiety may be induced therefrom.

In one embodiment, M in Chemical Formula 2 may be Rh, Ir, Pd, Pt, Ni, Rh, Co or Au.

In one embodiment, A may be represented by the following Chemical Formula 3.

<Chemical Formula 3>

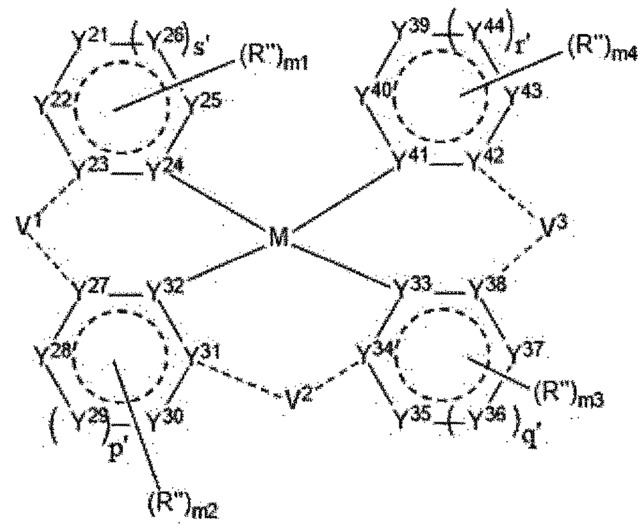

In Chemical Formula 3,

M is Pt,
$V^1$, $V^2$ and $V^3$ have the same definitions as in Chemical Formula 2,
s', p', q' and r' are each 0 or 1,
m1, m2, m3 and m4 are each an integer of 1 to 5,
$Y^{21}$ to $Y^{44}$ are each independently B, N, C, O, P, Si, S, Ge or Se, and the ring including a circle marked by a dotted line may not have a conjugated structure, or may partially or fully have a conjugated structure,
R"s are each independently at least one selected from the group consisting of hydrogen, deuterium, halogen, cyano, $-NO_2$, alkyl having 1 to 30 carbon atoms unsubstituted or substituted with an additional substituent, alkenyl having 2 to 30 carbon atoms unsubstituted or substituted with an additional substituent, alkynyl having 2 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heteroalkenyl having 2 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, allyl having 3 to 30 carbon atoms unsubstituted or substituted with an additional substituent, aryl having 6 to 30 carbon atoms unsubstituted or substituted with an additional substituent, heteroaryl having 2 to 30 carbon atoms unsubstituted or substituted with an additional substituent, $-B(R^{301})(R^{302})$,$-C(R^{303})(R^{304})(R^{305})$, $-Si(R^{306})(R^{307})(R^{308})$, $-Ge(R^{309})(R^{310})(R^{311})$,$-N(R^{312})(R^{313})$, $-P(R^{314})(R^{315})$, $-PO(R^{316})(R^{317})$, $-O(R^{318})$, $-S(R^{319})$, $-SO(R^{320})$, $-SO_2(R^{321})$, $Se(R^{322})$, $-SeO(R^{323})$, $-SeO_2(R^{324})$ and combinations thereof,
$R^{301}$ to $R^{324}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and at least two of $R^{301}$ to $R^{324}$ linked to one atom may be linked to form a ring, and
the additional substituent has the same definition as in Chemical Formula 1.

In one embodiment, A may be represented by any one of the following Chemical Formula 4 to Chemical Formula 8.

<Chemical Formula 4>

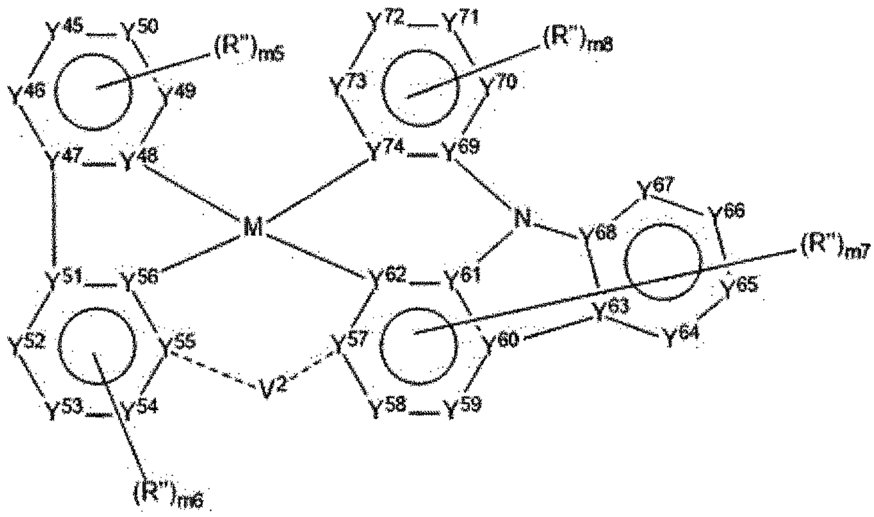

<Chemical Formula 5>

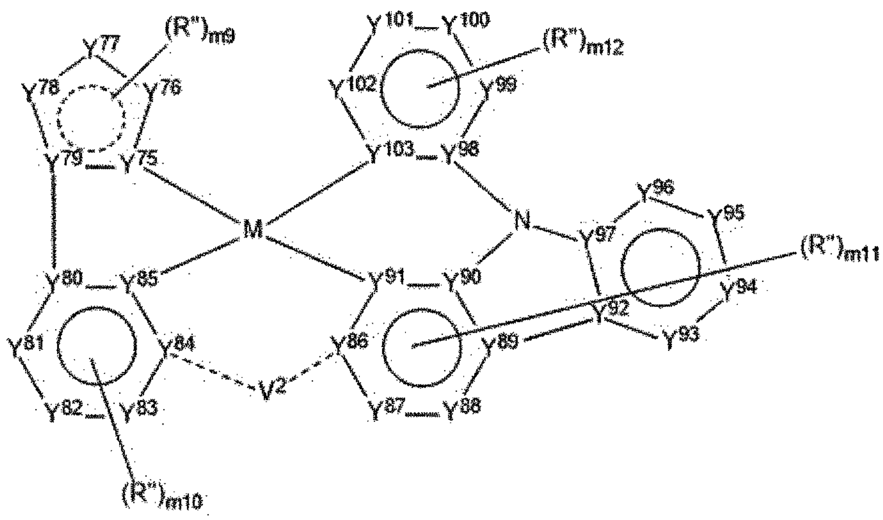

<Chemical Formula 6>

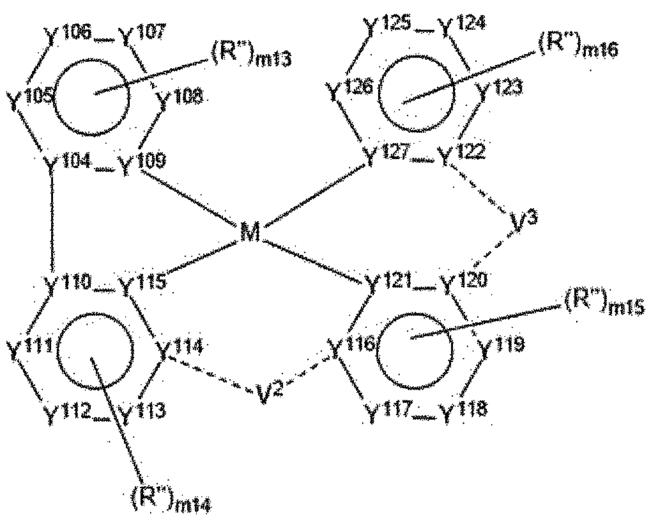

<Chemical Formula 7>

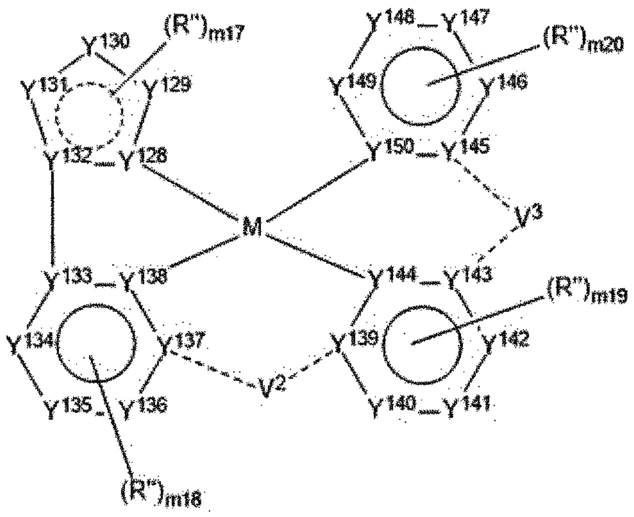

<Chemical Formula 8>

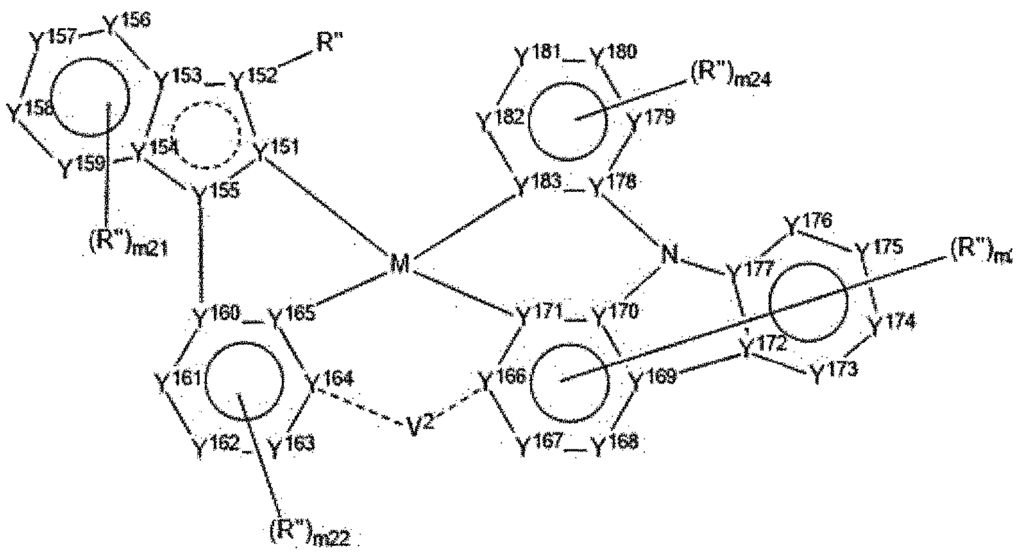

In Chemical Formula 4 to Chemical Formula 8,

M is Pt,

$V^2$ and $V^3$ are each independently not present, or a single bond, -B($Ar^5$)-, -N($Ar^5$)-, -O-, -S- or -Se-, and $Ar^5$s are each independently aryl having 6 to 30 carbon atoms unsubstituted or substituted with an additional substituent, heteroaryl having 2 to 30 carbon atoms unsubstituted or substituted with an additional substituent, alkyl having 1 to 30 carbon atoms unsubstituted or substituted with an additional substituent, cycloalkyl having 3 to 30 carbon atoms unsubstituted or substituted with an additional substituent, heterocycloalkyl having 2 to 30 carbon atoms unsubstituted or substituted with an additional substituent, cycloalkenyl having 3 to 30 carbon atoms unsubstituted or substituted with an additional substituent, or heterocycloalkenyl having 2 to 30 carbon atoms unsubstituted or substituted with an additional substituent,

m5, m6, m8, m10, m12, m13, m14, m18, m21, m22 and m24 are each an integer of 1 to 4,

m15, m16, m19 and m20 are each an integer of 1 to 5,

m7, m11 and m23 are each an integer of 1 to 7,

m9 and m17 are each an integer of 1 to 3,

$Y^{45}$ to $Y^{74}$, $Y^{80}$ to $Y^{127}$, $Y^{133}$ to $Y^{150}$, and $Y^{156}$ to $Y^{183}$ are each independently B, N or C,

$Y^{75}$ to $Y^{79}$, $Y^{128}$ to $Y^{132}$, and $Y^{151}$ to $Y^{155}$ are each independently B, N, C, O, S, Se, Te, Si, Ge or Sn,

the ring including a circle marked by a dotted line in Chemical Formula 5, Chemical Formula 7 and Chemical Formula 8

may not have a conjugated structure, or may partially or fully have a conjugated structure,

R"s are each independently at least one selected from the group consisting of hydrogen, deuterium, halogen, cyano, $-NO_2$, alkyl having 1 to 30 carbon atoms unsubstituted or substituted with an additional substituent, alkenyl having 2 to 30 carbon atoms unsubstituted or substituted with an additional substituent, alkynyl having 2 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heteroalkenyl having 2 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, allyl having 3 to 30 carbon atoms unsubstituted or substituted with an additional substituent, aryl having 6 to 30 carbon atoms unsubstituted or substituted with an additional substituent, heteroaryl having 2 to 30 carbon atoms unsubstituted or substituted with an additional substituent, $-B(R^{301})(R^{302})$,$-C(R^{303})(R^{304})(R^{305})$, $-Si(R^{306})(R^{307})(R^{308})$, $-Ge(R^{309})(R^{310})(R^{311})$,$-N(R^{312})(R^{313})$, $-P(R^{314})(R^{315})$, $-PO(R^{316})(R^{317})$, $-O(R^{318})$, $-S(R^{319})$, $-SO(R^{320})$, $-SO_2(R^{321})$, $Se(R^{322})$, $-SeO(R^{323})$, $-SeO_2(R^{324})$ and combinations thereof,

$R^{301}$ to $R^{324}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and at least two of $R^{301}$ to $R^{324}$ linked to one atom may be linked to form a ring, and

the additional substituent has the same definition as in Chemical Formula 1.

In one embodiment, A may be represented by any one of the following Structural Formulae A-1 to A-27.

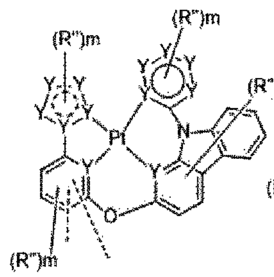
A-1

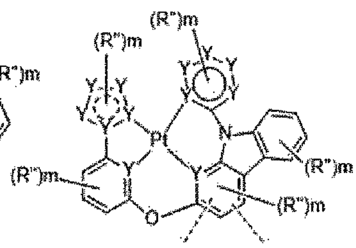
A-2

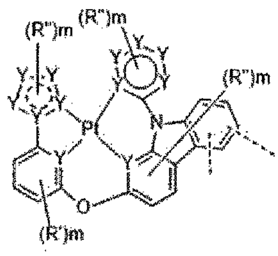
A-3

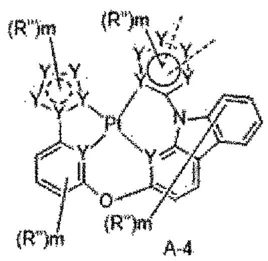
A-4

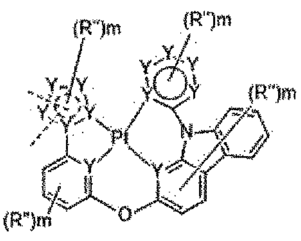
A-5

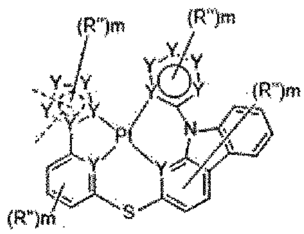
A-6

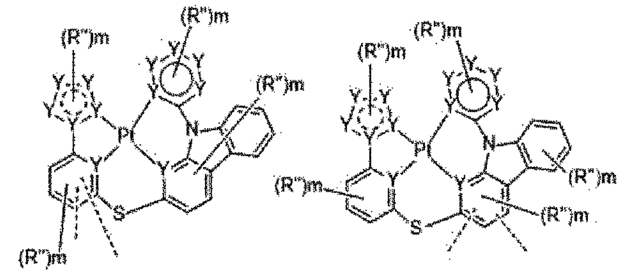

A-7 A-8

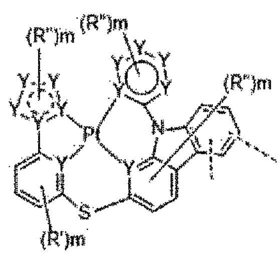

A-9

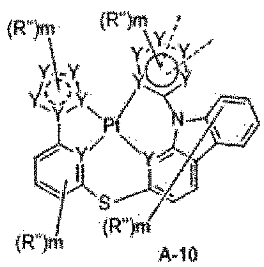

A-10

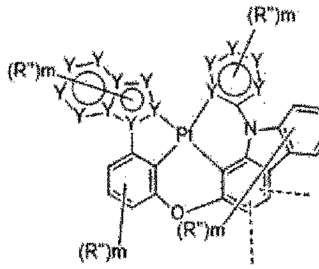

A-11

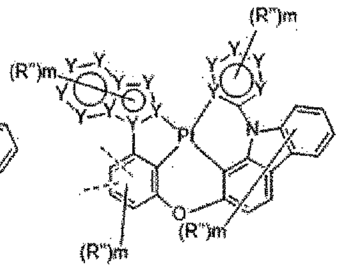

A-12

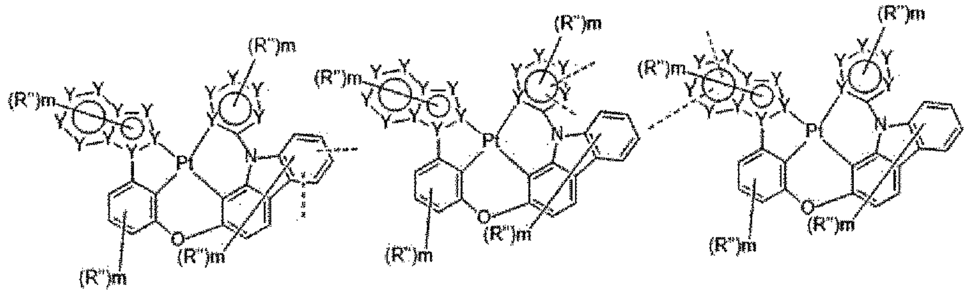

A-13 A-14 A-15

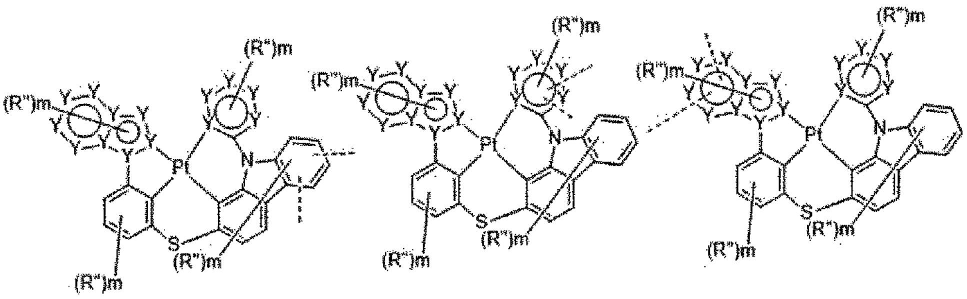

A-13 A-14 A-15

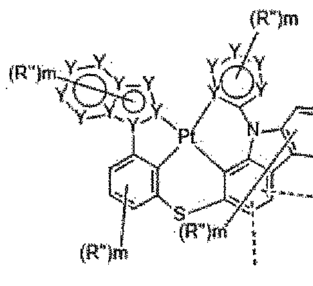

A-16

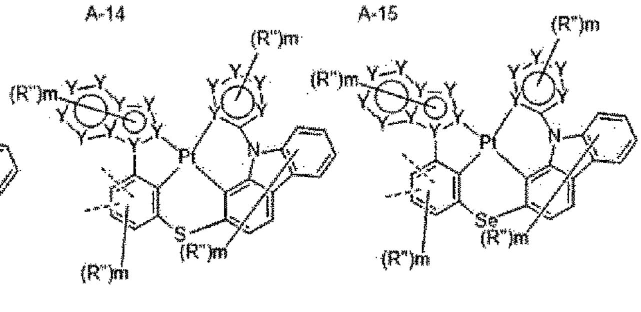

A-17 A-18

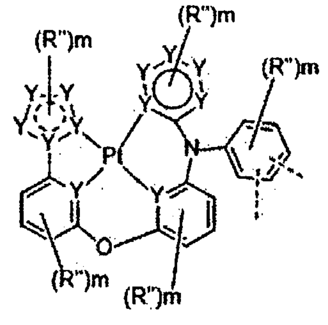

A-19

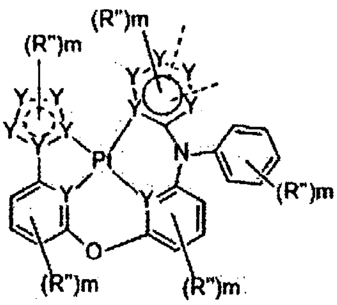

A-20

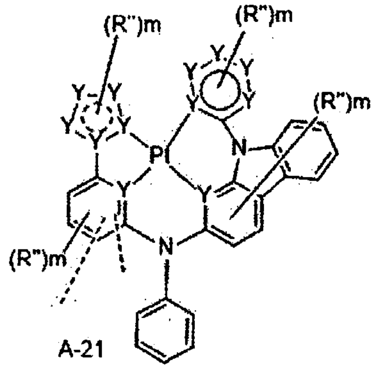

A-21

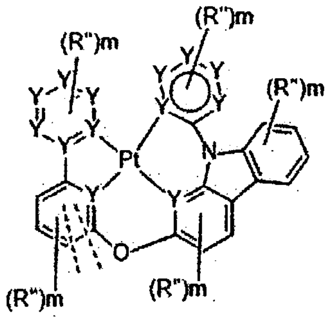

A-22

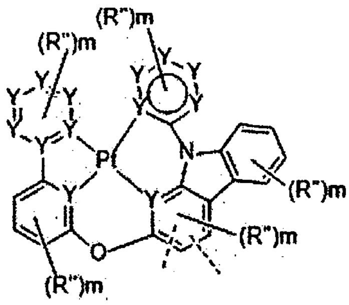

A-23

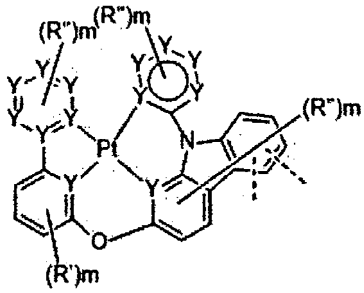

A-24

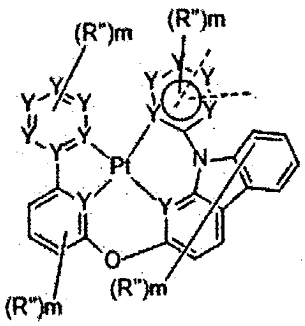

A-25

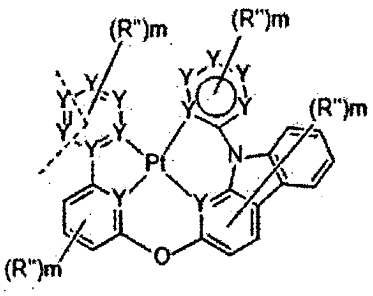

A-26

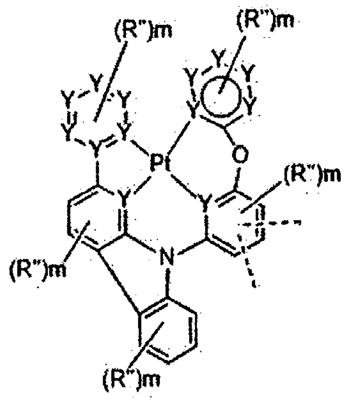

A-27

In A-1 to A-27,

Ys are each independently B, N, C, O, P, Si, S, Ge or Se,
m is an integer of 0 to a maximum number capable of having according to a stoichiometric ratio,
R"s are each independently at least one selected from the group consisting of hydrogen, deuterium, halogen, cyano, $-NO_2$, alkyl having 1 to 30 carbon atoms unsubstituted or substituted with an additional substituent, alkenyl having 2 to 30 carbon atoms unsubstituted or substituted with an additional substituent, alkynyl having 2 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heteroalkenyl having 2 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, allyl having 3 to 30 carbon atoms unsubstituted or substituted with an additional substituent, aryl having 6 to 30 carbon atoms unsubstituted or substituted with an additional substituent, heteroaryl having 2 to 30 carbon atoms unsubstituted or substituted with an additional substituent, $-B(R^{301})(R^{302})$,$-C(R^{303})(R^{304})(R^{305})$, $-Si(R^{306})(R^{307})(R^{308})$, $-Ge(R^{309})$

$(R^{310})(R^{311})$,-$N(R^{312})(R^{313})$, -$P(R^{314})(R^{315})$, -$PO(R^{316})(R^{317})$, -$O(R^{318})$, -$S(R^{319})$, -$SO(R^{320})$, -$SO_2(R^{321})$, $Se(R^{322})$, -$SeO(R^{323})$, -$SeO_2(R^{324})$ and combinations thereof,

$R^{301}$ to $R^{324}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and at least two of $R^{301}$ to $R^{324}$ linked to one atom may be linked to form a ring, and

the additional substituent has the same definition as in Chemical Formula 1.

In A-1 to A-27, when at least two of R"s are linked to each other to form a ring, such a ring includes a fused ring. In addition, when two of R"s are linked, it includes a case in which any one of the two R"s is hydrogen, and as the hydrogen is eliminated, the other R" is directly linked due to the reduction of the ring to which the hydrogen is linked.

The light-emitting mechanism of the light-emitting moiety may include fluorescence that light is emitted from a singlet, phosphorescence that light is emitted from a triplet, and thermally activated delayed fluorescence that light is emitted by transferring energy from a triplet to a singlet.

In one embodiment, Chemical Formula 1 may be any one of chemical formulae represented by the following B-1 to B-28.

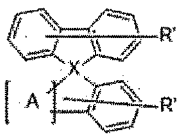
B-1

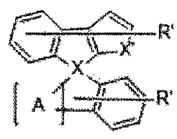
B-2

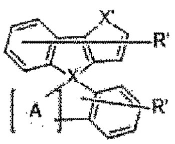
B-3

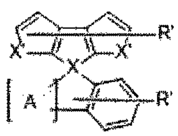
B-4

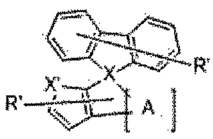
B-5

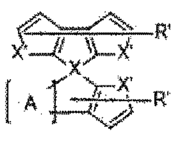
B-6

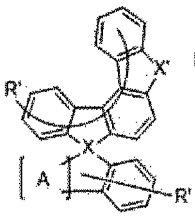
B-7

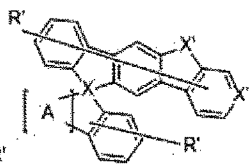
B-8

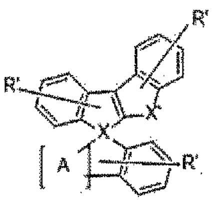
B-9

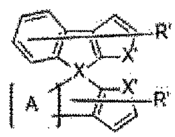
B-10

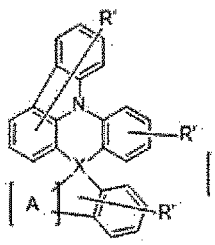
B-11

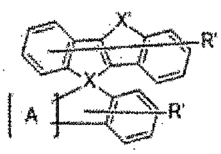
B-12

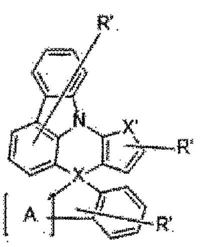
B-13

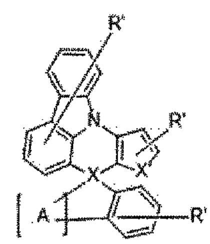
B-14

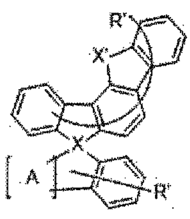
B-15

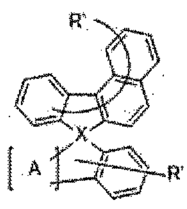
B-16

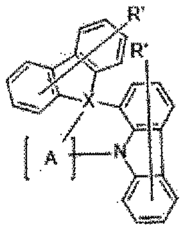
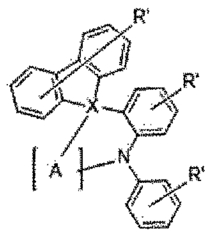
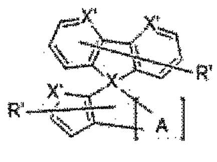
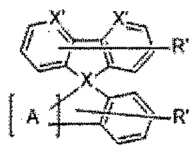

B-17 B-18 B-19 B-20

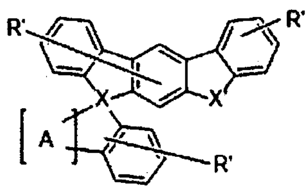
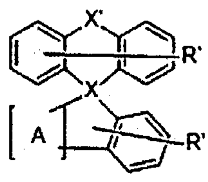
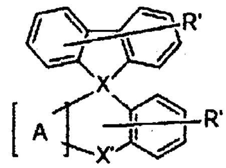
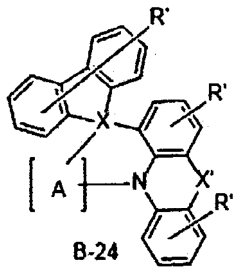

B-21 B-22 B-23 B-24

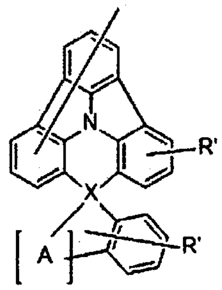
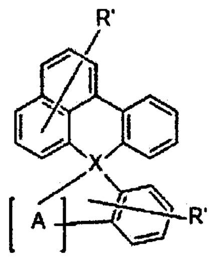
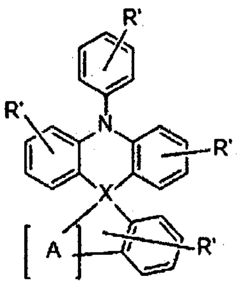
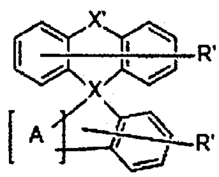

B-25 B-26 B-27 B-28

In B-1 to B-28,

A and X have the same definitions as in Chemical Formula 1,
X's linked by =X'- are each independently =C($Ar^7$)-, =N- or =B-,
X's linked by -X'- are each independently -O-,-S-, -Se-, -C($Ar^7$)($Ar^8$)-, -Si($Ar^7$)($Ar^8$) or -N($Ar^7$)-,
$Ar^7$ and $Ar^8$ in the definition of X' are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^7$ and $Ar^8$ may be linked to each other to form a ring, or may each be linked to an adjacent ring to form a fused ring,
R's may be present in the numbers capable of bonding according to a stoichiometric ratio, and are each independently at least one selected from the group consisting of hydrogen, deuterium, halogen, cyano, -$NO_2$, alkyl having 1 to 30 carbon atoms unsubstituted or substituted with an additional substituent, alkenyl having 2 to 30 carbon atoms unsubstituted or substituted with an additional substituent, alkynyl having 2 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heteroalkenyl having 2 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, allyl having 3 to 30 carbon atoms unsubstituted or substituted with an additional substituent, aryl having 6 to 30 carbon atoms unsubstituted or substituted with an additional substituent, heteroaryl having 2 to 30 carbon atoms unsubstituted or substituted with an

additional substituent, $-B(R^{101})(R^{102})$, $-C(R^{103})(R^{104})(R^{105})$,$-Si(R^{106})(R^{107})(R^{108})$, $-Ge(R^{109})(R^{110})(R^{111})$, $-N(R^{112})(R^{113})$,$-P(R^{114})(R^{115})$, $-PO(R^{116})(R^{117})$, $-O(R^{118})$, $-S(R^{119})$, $-SO(R^{120})$,$-SO_2(R^{121})$, , $Se(R^{122})$, $-SeO(R^{123})$, $-SeO_2(R^{124})$ and combinations thereof,

$R^{101}$ to $R^{124}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and at least two of $R^{101}$ to $R^{124}$ linked to one atom may be linked to form a ring, and

the additional substituent has the same definition as in Chemical Formula 1.

In one embodiment, the complex light-emitting compound may include at least one deuterium.

In one embodiment, the complex light-emitting compound may be any one of the following compounds.

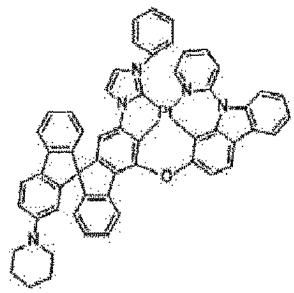

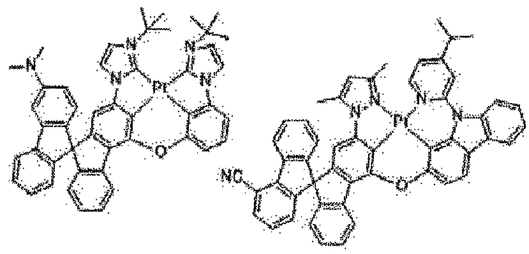

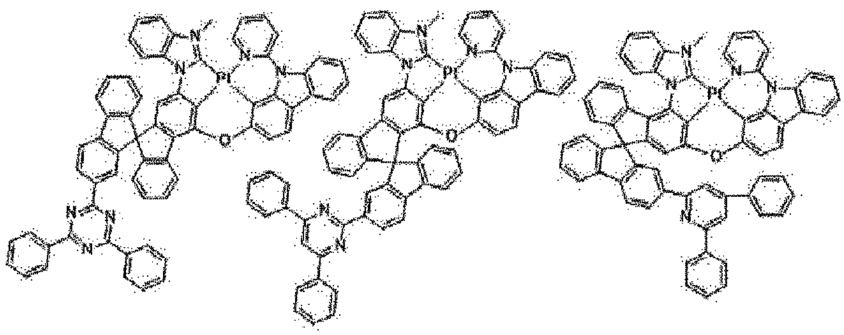

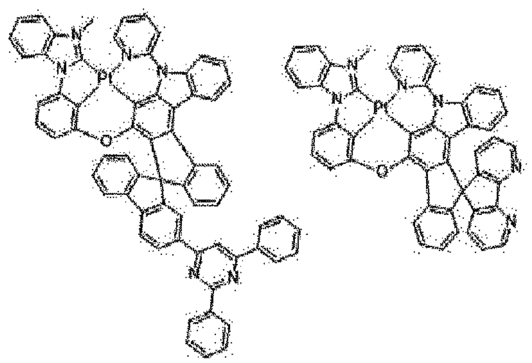

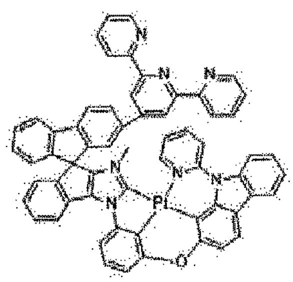

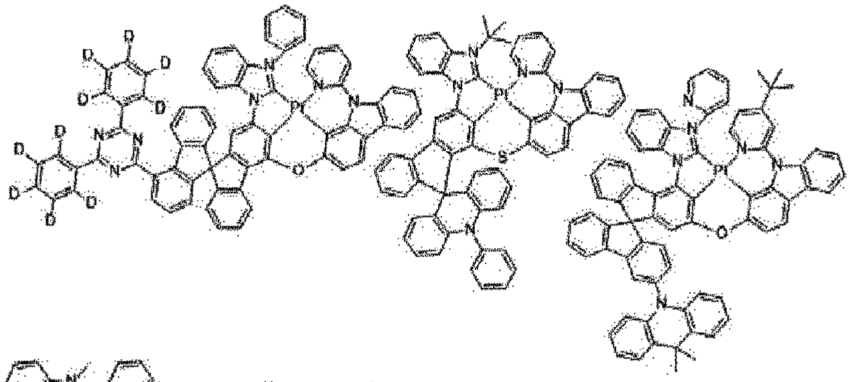

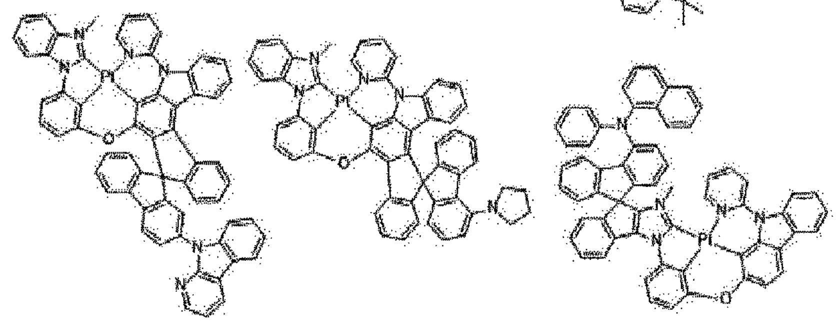

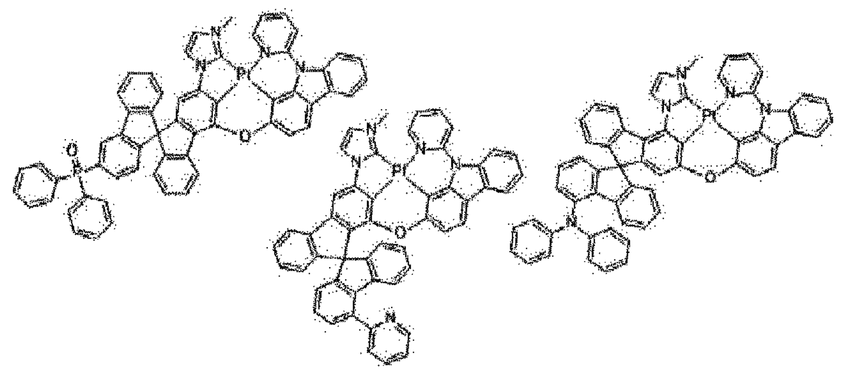

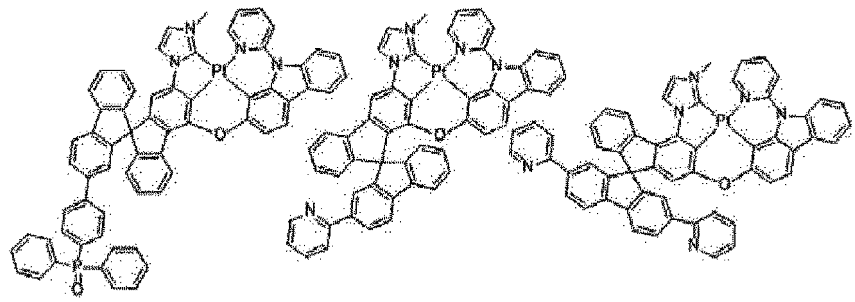

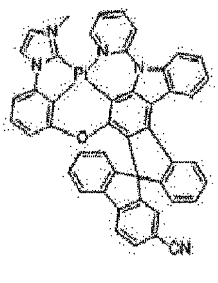

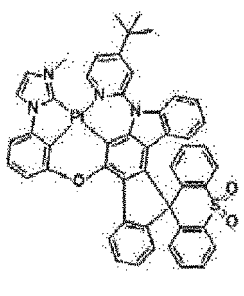

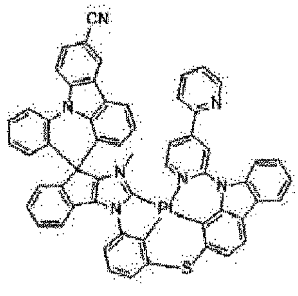

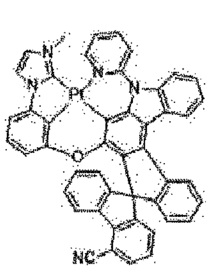
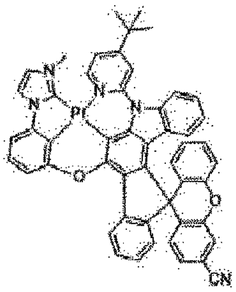
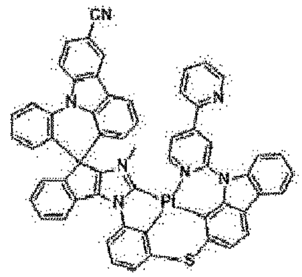

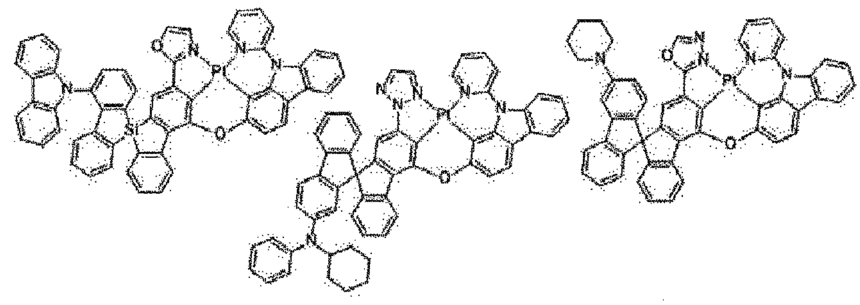

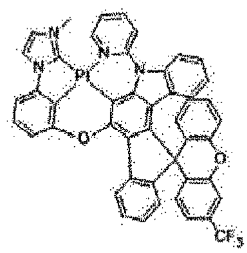
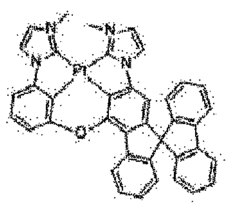
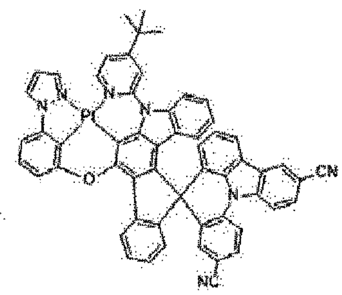

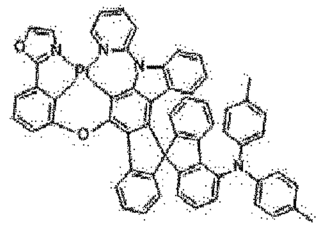
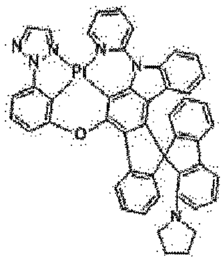
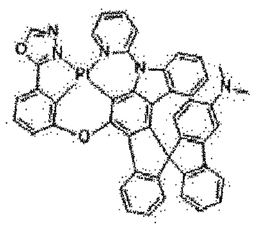

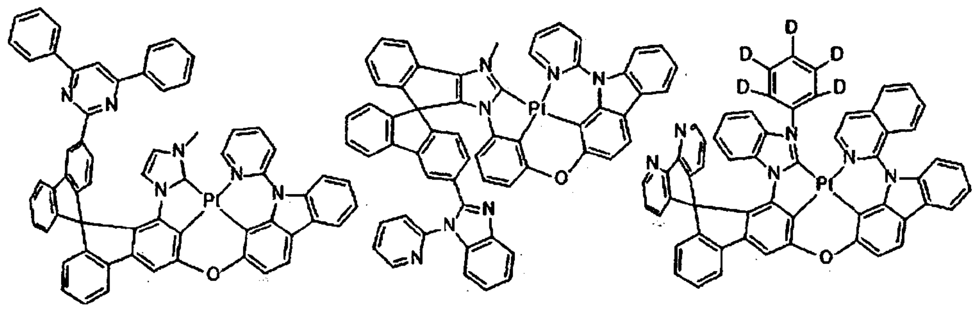

The charge-stabilizing moiety of the complex light-emitting compound stabilizes the light-emitting moiety at a close distance when the light-emitting moiety is present in an ionized state by trapping charges or in an excited state, without significantly affecting inherent luminescence properties of the light-emitting moiety. In addition, the charge-stabilizing moiety significantly reduces the probability of chemical interaction and Coulomb interaction with surrounding other dopant materials, host materials and excitons by protecting a certain portion of the light-emitting moiety while

maintaining spatial position and angle that do not cause chemical interaction with the light-emitting moiety.

For the above-mentioned reasons, the complex light-emitting compound may increase luminescence stability in driving the organic light-emitting diode device.

In one embodiment, the light-emitting layer may include at least two types of the complex light-emitting compound.

The organic light-emitting diode may include the complex light-emitting compound at a level equal to or higher than a common dopant content level. This means that the content of the light-emitting moiety may be the same as or higher than the dopant content level. The content of the complex light-emitting compound in the light-emitting layer may be, for example, in a range of 0.1 mol% to 100 mol% in all the materials forming the light-emitting layer, and the ratio may be properly adjusted depending on the application.

In one embodiment, the light-emitting layer may further include at least one selected from the group consisting of a host, an additional dopant and combinations thereof.

The host may be a material generally known as a host material capable of forming a light-emitting layer.

The additional dopant may be a material known as a light-emitting material or a material generally known as a dopant doped as a light-emitting material in a light-emitting layer. The additional dopant may perform a role of re-emitting by absorbing emission energy of the light-emitting moiety. Accordingly, the maximum emission wavelength energy of the additional dopant may be smaller than the highest emission wavelength energy of the light-emitting moiety. Emission of low energy may be obtained by using the additional dopant.

The highest emission wavelength energy means a wavelength having the largest photon energy in the emission spectrum. The highest emission wavelength is obtained from an onset value at the position where emission starts, and the maximum emission wavelength is obtained from the wavelength having the highest luminescence intensity.

The organic light-emitting diode may further include a phosphorescent material in the light-emitting layer in order to further increase luminous efficiency of the light-emitting layer.

In one embodiment, the light-emitting layer may further include a phosphorescent material including Pt or Ir.

Compounds represented by the following structural formulae are examples of organometallic complexes commonly used as the phosphorescent material.

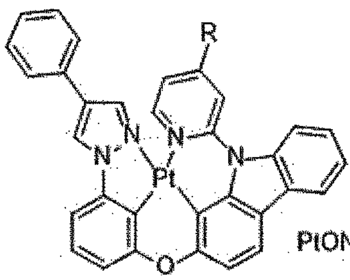

PtON6-tBu

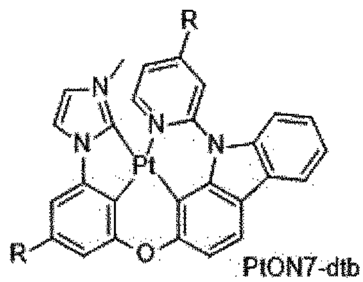

PtON7-dtb

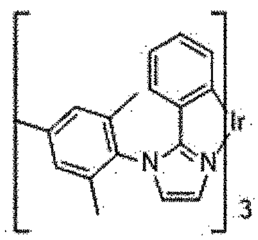

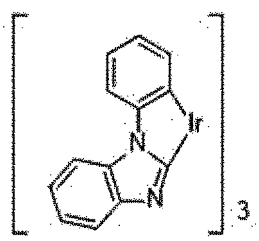

In the formulae, Rs may each be alkyl having 1 to 20 carbon atoms, cycloalkyl having 3 to 20 carbon atoms, heterocycloalkyl having 2 to 20 carbon atoms, aryl having 6 to 30 carbon atoms, and the like.

The organic light-emitting diode may further include a delayed fluorescent material in the light-emitting layer in order to further increase luminous efficiency of the light-emitting layer.

In one embodiment, the light-emitting layer may further include a delayed fluorescent material in which an energy difference between a singlet and a triplet is 0.3 eV or greater.

Compounds represented by the following structural formulae are examples of the delayed fluorescent material commonly used.

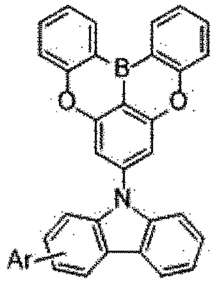

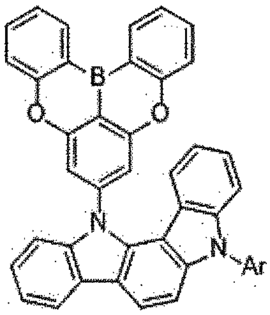

In the formulae, Ars may each be alkyl having 1 to 20 carbon atoms, cycloalkyl having 3 to 20 carbon atoms, heterocycloalkyl having 2 to 20 carbon atoms, aryl having 6 to 30 carbon atoms, and the like.

The organic light-emitting diode may include one selected from the group consisting of a hole injection layer, a hole transport layer, an electron blocking layer, a hole blocking layer, an electron transport layer, an electron injection layer and combinations thereof as the organic layer.

In one embodiment, the organic light-emitting diode may sequentially include an anode, a hole injection layer (HIL), a hole transport layer (HTL), a light-emitting layer (EML), an electron transport layer (ETL) and a cathode.

The organic light-emitting diode may be a tandem-type organic light-emitting diode including a plurality of organic light-emitting units.

The plurality of organic light-emitting units may be sequentially laminated, and a charge generation layer (CGL) may be included between each of the organic light-emitting units. The charge generation layer is located between the organic light-emitting units so as to smoothly distribute charges to the light-emitting layer of each organic light-emitting unit.

In the tandem-type organic light-emitting diode, the organic light-emitting unit may include an organic layer including one selected from the group consisting of a light-emitting layer, a hole injection layer, a hole transport layer, an electron blocking layer, a hole blocking layer, an electron transport layer, an electron injection layer and combinations thereof.

In the tandem-type organic light-emitting diode, at least one organic light-emitting unit includes the light-emitting layer including the complex light-emitting compound.

In the tandem-type organic light-emitting diode, detailed description on the complex light-emitting compound is the same as the description stated above.

**[Synthesis Example]**

<u>Synthesis of Comparative Compound 1</u>

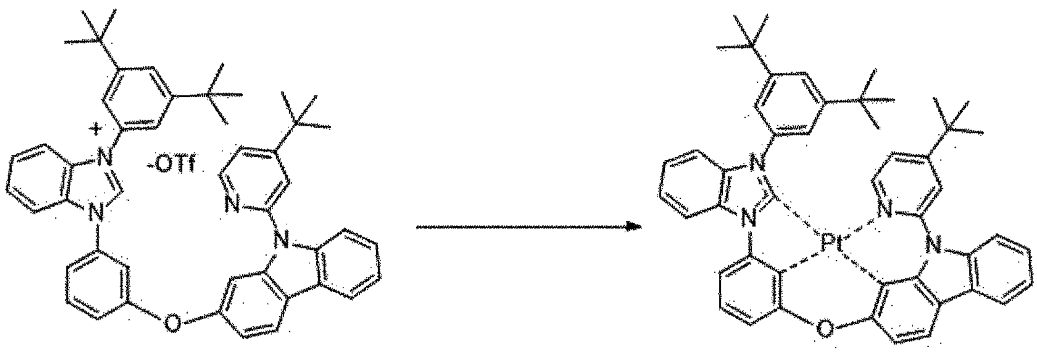

Comparative Compound 1-1 Comparative

Compound 1

After dissolving Comparative Compound 1-1 (7.00 g, 8.3 mmol), dichloro(cycloocta-1,5-diene)platinum(II) (3.72 g, 9.9 mmol) and sodium acetate (2.04 g, 24.8 mmol) in 1,4-dioxane (83 ml) under a nitrogen atmosphere, the temperature was raised to 115°C to 120°C, and the mixture was stirred for 16 hours.

The reaction solution was cooled to room temperature, concentrated under reduced pressure, and then

extracted with dichloromethane. The organic layer was dried with $MgSO_4$, and then filtered. The filtrate was concentrated under reduced pressure, and then purified using a silica gel column chromatography (DCM/hexane) method.

After that, the result was purified through recrystallization using a mixed solvent of DCM/hexane to obtain Comparative Compound 1 (2.21 g) in a yield of 30%.

MS(ACPI) m/z: 890[M+H]
NMR: δH (500 MHz; $CDCl_3$; $Me_4Si$) 8.71 (d, J=6.3 Hz, 1H), 8.15 (d, J=8.3 Hz, 1H), 7.99-7.98 (m, 1H), 7.82 (d, J=8.3 Hz, 1H), 7.60-7.58 (m, 1H), 7.54 (s, 1H), 7.51-7.47 (m, 3H), 7.43 (d, J=8.38 Hz, 1H), 7.36-7.33 (m, 2H), 7.29-7.26 (m, 4H), 7.09 (d, J=8.1 Hz, 1H), 7.01 (t, J=7.7 Hz, 1H), 5.52 (d, J=3.2 Hz, 1H), 1.50 (br, 9H), 0.99 (br, s. 9H), 0.82 (s, 9H).

Synthesis of Compound 2

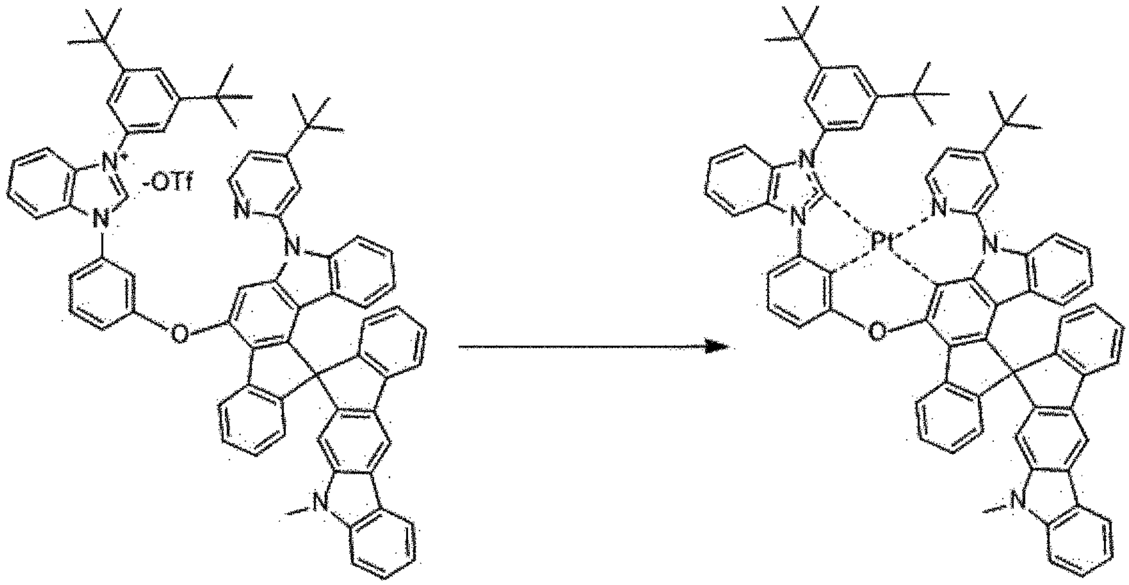

Compound 2-1 Compound 2

Compound 2 was synthesized in the same manner as above (Synthesis of Comparative Compound 1), except that Compound 2-1 was used instead of Comparative Compound 1-1 in the same molar ratio.

After final purification, Compound 2 was obtained (2.04 g) in a yield of 20%.

MS(ACPI) m/z: 1231[M+H]
NMR: δH (500 MHz; $CDCl_3$; $Me_4Si$) 8.95-8.93 (1H, d, J=7.78 Hz), 8.78-8.77 (1H, d, J=5.95 Hz), 8.69 (1H, s), 8.28-8.26 (1H, d, J=8.23 Hz), 8.22-8.20 (1H, d, J=8.23 Hz), 8.12-8.10 (1H, d, J=7.55 Hz), 7.70-7.33 (15H, m), 7.25-7.21 (2H, m), 7.02-6.98 (3H, m), 6.88-6.85 (2H, m), 6.74-6.72 (1H, d, J= 8.00), 6.67-6.63 (2H, d), 3.48 (3H, s), 1.55 (9H, s), 1.01 (18H, br.s).

Synthesis of Compound 3

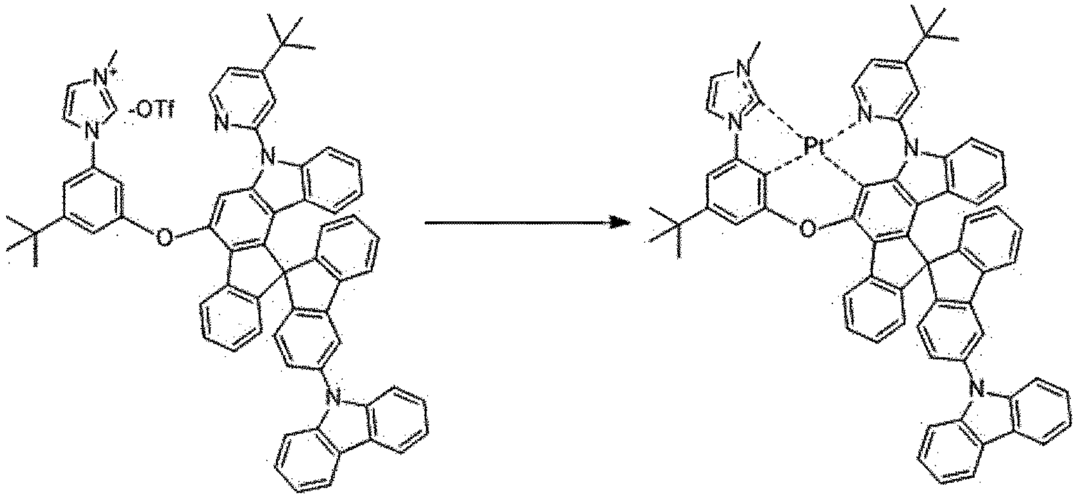

Compound 3-1 Compound 3

Compound 3 was synthesized in the same manner as above (Synthesis of Comparative Compound 1), except that Compound 3-1 was used instead of Comparative Compound 1-1 in the same molar ratio.

After final purification, Compound 3 was obtained (1.86 g) in a yield of 20%.

MS(ACPI) m/z: 1125[M+H]

NMR: δH (500 MHz; $CDCl_3$; $Me_4Si$) 9.40-9.38 (1H, d, J=6.18 Hz), 8.93-8.91 (1H, d, J=7.78 Hz), 8.17-8.15 (3H, d, J=7.78 Hz), 8.00-7.96 (2H, m), 7.70-7.68 (1H, d, J=8.23 Hz), 7.51-7.37 (9H, m), 7.32-7.28 (2H, m), 7.19-7.15 (2H, m), 7.12-7.08 (2H, m), 7.05 (2H, s), 6.94-6.92 (2H, m), 6.88-6.92 (2H, t, J=7.55 Hz, 7.55 Hz), 6.76-6.73 (2H, m), 3.91 (3H, s), 1.51 (9H, s), 1.26 (9H, s).

Synthesis of Compound 4

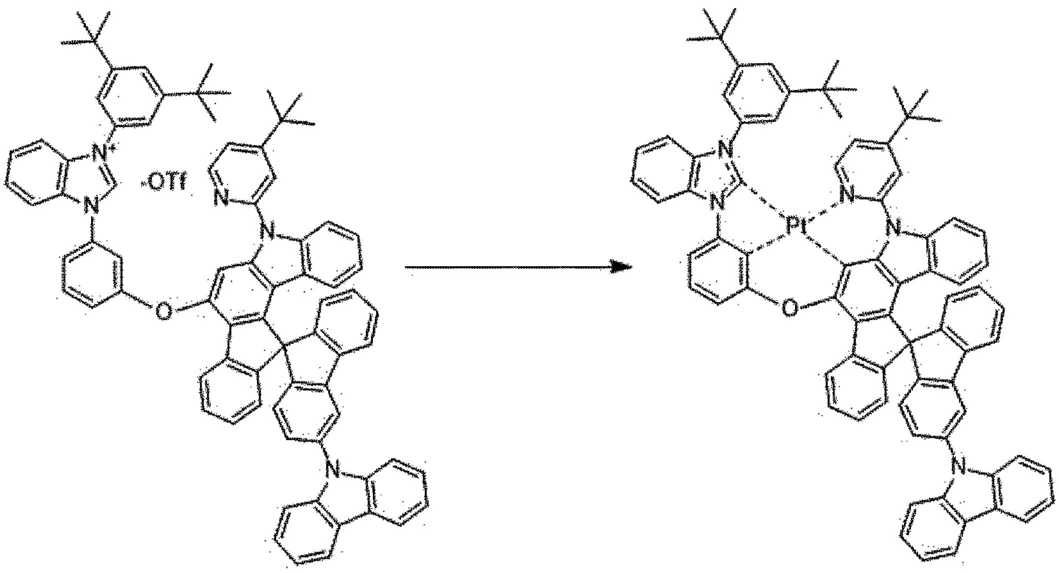

Compound 4-1 Compound 4

Compound 4 was synthesized in the same manner as above (Synthesis of Comparative Compound 1), except that Compound 4-1 was used instead of Comparative Compound 1-1 in the same molar ratio.

After final purification, Compound 4 was obtained (2.24 g) in a yield of 21%.

MS(ACPI) m/z: 1293[M+H]

NMR: δH (500 MHz; $CDCl_3$; $Me_4Si$) 8.97-8.95 (1H, d, J=7.55 Hz), 8.82-8.81 (1H, d, J=6.40 Hz), 8.27-8.25 (1H, d, J=8.23 Hz), 8.17-8.16 (3H, d, J=5.72 Hz), 7.98-7.96 (1H, d, J=7.55 Hz), 7.70 (1H, s), 7.59-7.38 (17H, m), 7.32-7.28 (3H, d, J=8.00 Hz), 7.24-7.22 (1H, d, J=6.63 Hz), 7.13-7.10 (3H, t, J=7.32 Hz), 6.92-6.91 (1H, m), 6.87-6.83 (1H, t, J=7.66 Hz, 7.66 Hz), 6.77-6.75 (2H, d), 1.55 (9H, s), 0.98 (18H, s).

**[Device Example]**

An ITO surface was treated with UV ozone for 3 minutes at atmospheric pressure.

In a $10^{-7}$ torr vacuum chamber, processes were performed in the following order to manufacture a device.

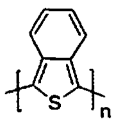
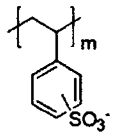

PEDOT:PSS

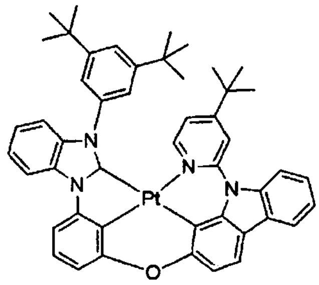

비교 화합물 1

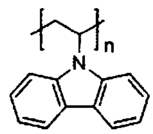

화합물 A

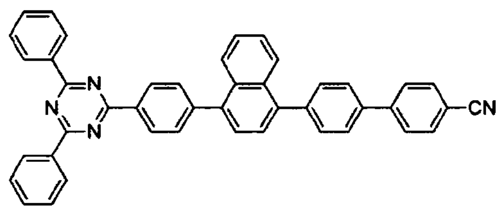

화합물 B

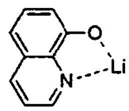

Liq

비교 화합물 1: Comparative Compound

화합물 A: Compound A

화합물 B: Compound B

**Device 1 (Comparative Example 1)**

As a hole injection material, PEDOT:PSS was spin-coated for 1 minute at 4000 rpm, and heated for 10 minutes at 120°C. As a light-emitting layer, Comparative Compound 1 (0.0046 g) and Compound A (0.0154 g) were dissolved in toluene (2 ml), and the mixture was spin-coated for 1 minute at 1000 rpm and then heated for 10 minutes at 60°C under vacuum. As an electron transport layer, Compound B and LiQ were deposited in a ratio of 1:1 to a thickness of 300 Å. As an electrode, Al was deposited to a thickness of 1000 Å.

**Device 2 (Example 1)**

Device 2 was manufactured in the same manner as in Device 1, except that the light-emitting layer of Device 1 was doped with 20 mol% of Compound 2.

The doping mol% representing maximum luminous efficiency in each device was measured below under a condition of 10 $mA/cm^2$.

[Table 1]

| Device (10 mA/cm$^2$) | | Dopant | Doping mol% | Maximum EQE(%) | CIE x | CIE y | λmax |
|---|---|---|---|---|---|---|---|
| Comparative Example 1 | Device 1 | Comparative Compound 1 | 20 | 3.55 | 0.158 | 0.179 | 456 |
| Example 1 | Device 2 | Compound 2 | 20 | 4.41 | 0.153 | 0.156 | 456 |

As may be identified in Table 1, the device of the present invention shows high efficiency properties. The difference between Comparative Compound 1 and Compound 2 is inclusion of a carbazole unit. The advantage of the charge-stabilizing unit mentioned in the present invention is an excellent property of increasing luminescence stability of a light-emitting material, and it may be decided that Compound 2 shows high efficiency by including a carbazole unit including an unshared electron pair and thereby increasing luminescence stability of a light-emitting material, and shows a property of a deeper blue color in the CIE y value of the CIE standard color coordinate system by minimizing a concentration quenching phenomenon between the light-emitting units.

Hereinbefore, the present invention has been described with reference to accompanying drawings, however, the present invention is not limited by the embodiments and the drawings disclosed in the present specification, and it is obvious that various modifications may be made by those skilled in the art within the scope of technical ideas of the present invention. In addition, even when working effects obtained from the constitutions of the present invention are not explicitly described while describing the embodiments of the present invention, it is logical that effects predictable by the corresponding constitutions need to be acknowledged as well.

## Claims

**1.** An organic light-emitting diode comprising:

a first electrode;
a second electrode; and
a light-emitting layer interposed between the first electrode and the second electrode,
wherein the light-emitting layer includes a complex light-emitting compound represented by the following Chemical Formula 1,
the complex light-emitting compound includes a light-emitting moiety and a charge-stabilizing moiety, the light-emitting moiety and the charge-stabilizing moiety are linked through atom X, and atom X is X presented in the following Chemical Formula 1,
the light-emitting moiety includes A, a conjugated ring formed to include $Y^1$ to $Y^5$, and Q in the following Chemical Formula 1,
the charge-stabilizing moiety includes a ring formed to include $Y^6$ to $Y^{10}$, a ring formed to include $Y^{11}$ to $Y^{15}$, and Z in the following Chemical Formula 1, and
the charge-stabilizing moiety includes at least one atom having an unshared electron pair:

<Chemical Formula 1>

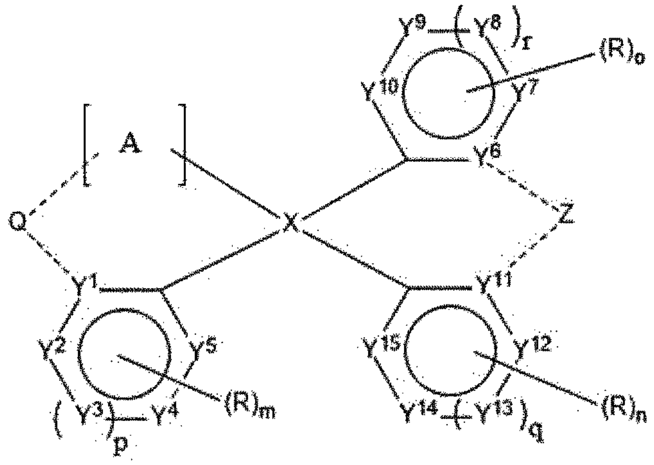

in Chemical Formula 1,

A is a structure represented by the following Chemical Formula 2, and is linked through a first linking position of A, or linked through a first linking position and a second linking position of A,

X is C, Si, Ge, Sn or Pb, and the first linking position of A is linked to X,

Q is not present, or a single bond, -B($Ar^1$)-,-C($Ar^1$)($Ar^2$)-, -Si($Ar^1$)($Ar^2$)-, -Ge($Ar^1$)($Ar^2$)-, -N($Ar^1$)-,-P($Ar^1$)-, -PO(Ar)-, -O-, -S-, -SO-, -$SO_2$-, -Se-, -SeO-, -$SeO_2$-, -CO-, -CS- or -CSe-, and herein, $Ar^1$ and $Ar^2$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^1$ and $Ar^2$ may be linked to each other to form a ring, or may each be linked to $Y^2$, R that is linked to $Y^2$, or A to form a fused ring,

when Q is not present, A is not directly linked to $Y^1$ at the second linking position of A,

when Q is a single bond, A is linked to $Y^1$ by a single bond at the second linking position of A,

when Q is not a single bond and is present as any one defined as above, A is linked to Q at the second linking position of A,

when Q is not a single bond and is present as any one defined as above, Q is linked to A and $Y^1$ each by a single bond,

$Y^1$ to $Y^{15}$ are each independently boron, carbon, nitrogen, oxygen, sulfur, Se or Te,

Z is not present, or a single bond, -B($Ar^3$)-,-C($Ar^3$)($Ar^4$)-, -Si($Ar^3$)($Ar^4$)-, -Ge($Ar^3$)($Ar^4$)-, -N($Ar^3$)-,-P($Ar^4$)-, -PO($Ar^3$)-, -O-, -S-, -SO-, -$SO_2$-, -Se-, -SeO-, -$SeO_2$-, -CO-, -CS- or -CSe-, and herein, $Ar^3$ and $Ar^4$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^3$ and $Ar^4$ may be linked to each other to form a ring, or may each be linked to any one of $Y^7$, $Y^{12}$, R that is linked to $Y^7$ or R that is linked to $Y^{12}$ to form a fused ring,

when Z is not present, $Y^6$ and $Y^{11}$ are not directly linked,

when Z is a single bond, $Y^6$ and $Y^{11}$ are linked by a single bond,

when Z is not a single bond and is present as any one defined as above, Z is linked to $Y^6$ and $Y^{11}$ each by a single bond,

m, n and o are each independently an integer of 0 to 5,

Rs are each independently at least one selected from the group consisting of hydrogen, deuterium, halogen, cyano, -$NO_2$, alkyl having 1 to 30 carbon atoms unsubstituted or substituted with an additional substituent, alkenyl having 2 to 30 carbon atoms unsubstituted or substituted with an additional substituent, alkynyl having 2 to 30

carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heteroalkenyl having 2 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent,

allyl having 3 to 30 carbon atoms unsubstituted or substituted with an additional substituent, aryl having 6 to 30 carbon atoms unsubstituted or substituted with an additional substituent, heteroaryl having 2 to 30 carbon atoms unsubstituted or substituted with an additional substituent, $-B(R^{101})(R^{102})$, $-C(R^{103})(R^{104})(R^{105})$,$-Si(R^{106})(R^{107})(R^{108})$, $-Ge(R^{109})(R^{110})(R^{111})$, $-N(R^{112})(R^{113})$,$-P(R^{114})(R^{115})$, $-PO(R^{116})(R^{117})$, $-O(R^{118})$, $-S(R^{119})$, $-SO(R^{120})$,$-SO_2(R^{121})$, $Se(R^{122})$, $-SeO(R^{123})$, $-SeO_2(R^{124})$ and combinations thereof,

$R^{101}$ to $R^{124}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and at least two of $R^{101}$ to $R^{124}$ linked to one atom may be linked to form a ring,

at least two Rs present when m, n or o is 2 or greater may be linked to each other to form a ring,

p, q and r each independently represent 0 or 1, and when p, q or r is 0, it means that a 5-membered ring is formed, and when p, q or r is 1, it means that a 6-membered ring is formed,

however, at least one atom of $Y^6$ to $Y^{15}$ and Z is an atom including an unshared electron pair, or R bonding thereto includes at least one atom including an unshared electron pair,

<Chemical Formula 2>

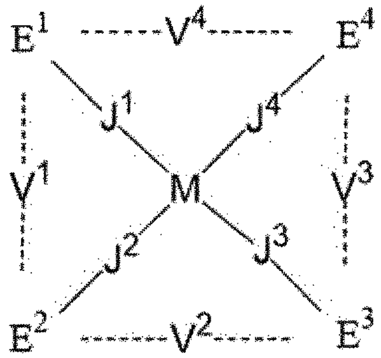

in Chemical Formula 2,

M is a transition metal;

$V^1$, $V^2$, $V^3$ and $V^4$ are each independently not present, or a single bond, $-B(Ar^5)-$, $-C(Ar^5)(Ar^6)-$, $-Si(Ar^5)(Ar^6)-$,$-Ge(Ar^5)(Ar^6)-$, $-N(Ar^5)-$, $-P(Ar^5)-$, $-PO(Ar^5)-$, -O-, -S-, -SO-, $-SO_2-$, -Se-, -SeO-, $-SeO_2-$, -CO-, -CS- or -CSe-, and herein, $Ar^5$ and $Ar^6$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^5$ and $Ar^6$ are optionally linked to each other to form a ring, or each optionally linked to adjacent $E^1$, $E^2$, $E^3$ or $E^4$ to form a fused ring;

however, at least one of $V^1$, $V^2$, $V^3$ and $V^4$ is a single bond;

when $V^1$, $V^2$, $V^3$ and $V^4$ are not present, two of the adjacent $E^1$, $E^2$, $E^3$ and $E^4$ are not directly linked;
when $V^1$, $V^2$, $V^3$ and $V^4$ are a single bond, two of the adjacent $E^1$, $E^2$, $E^3$ and $E^4$ are directly linked by a single bond, and when $V^1$, $V^2$, $V^3$ and $V^4$ are not a single bond and are present as any one defined as above, they are linked to two of the adjacent $E^1$, $E^2$, $E^3$ and $E^4$ each by a single bond, or two bonds linked to two of the adjacent $E^1$, $E^2$, $E^3$ and $E^4$ optionally form a conjugated structure together;
$J^1$, $J^2$, $J^3$ and $J^4$ are each a single bond, O or S;
when $J^1$, $J^2$, $J^3$ and $J^4$ are a single bond, any one of $E^1$, $E^2$, $E^3$ and $E^4$ linked thereto directly bonds to M by a coordination bond or a covalent bond;
when $J^1$, $J^2$, $J^3$ and $J^4$ are O or S, the bond with M is a coordination bond or a covalent bond;
$E^1$, $E^2$, $E^3$ and $E^4$ are each independently a monovalent, divalent or trivalent group and defined as below, provided that, when $E^1$, $E^2$, $E^3$ and $E^4$ are a monovalent group, the adjacent two of $V^1$, $V^2$, $V^3$ and $V^4$ are both absent; when $E^1$, $E^2$, $E^3$ and $E^4$ are a divalent group, any one of the adjacent two of $V^1$, $V^2$, $V^3$ and $V^4$ is not present; and when $E^1$, $E^2$, $E^3$ and $E^4$ are a trivalent group, the adjacent two of $V^1$, $V^2$, $V^3$ and $V^4$ are both present;
$E^1$, $E^2$, $E^3$ and $E^4$ are each independently a monovalent group of halogen or cyano, or saturated or unsaturated aliphatic hydrocarbon having 1 to 50 carbon atoms unsubstituted or substituted with an additional substituent; saturated or unsaturated heteroatom-containing aliphatic hydrocarbon having 1 to 50 carbon atoms unsubstituted or substituted with an additional substituent; an aromatic carbon ring having 5 to 50 carbon atoms unsubstituted or substituted with an additional substituent; an aromatic heteroring having 2 to 50 carbon atoms unsubstituted or substituted with an additional substituent; a saturated or unsaturated alicyclic carbon ring having 3 to 50 carbon atoms unsubstituted or substituted with an additional substituent; or a saturated or unsaturated alicyclic heteroring having 2 to 50 carbon atoms unsubstituted or substituted with an additional substituent;
at least two additional substituents included in $E^1$, $E^2$, $E^3$ and $E^4$ are optionally linked to form a ring;
however, when $J^1$, $J^2$, $J^3$ or $J^4$ is a single bond, the atom at the linking position from the adjacent $E^1$, $E^2$, $E^3$ or $E^4$ to M is carbon, nitrogen, oxygen, sulfur or phosphorous; or when $J^1$, $J^2$, $J^3$ or $J^4$ is O or S, the atom at the linking position from the adjacent $E^1$, $E^2$, $E^3$ or $E^4$ to O or S of $J^1$, $J^2$, $J^3$ or $J^4$ is carbon;
in any one of $E^1$, $E^2$, $E^3$ and $E^4$, the linking position to the adjacent $J^1$, $J^2$, $J^3$ or $J^4$ and the linking position to the adjacent $V^1$, $V^2$, $V^3$ or $V^4$ are adjacent to each other;
in any one of $E^1$, $E^2$, $E^3$ and $E^4$, the linking positions to two of the adjacent $V^1$, $V^2$, $V^3$ and $V^4$ are different from each other;
an atom capable of bonding according to a stoichiometric ratio except for M in Chemical Formula 2 is optionally the first linking position or the second linking position of A in Chemical Formula 1, provided that, the first linking position and the second linking position are each (i) different from the linking position from any one of $E^1$, $E^2$, $E^3$ and $E^4$ to the adjacent $J^1$, $J^2$, $J^3$, $J^4$, $V^1$, $V^2$, $V^3$ or $V^4$, and (ii) different from the linking position from any one of $V^1$, $V^2$, $V^3$ and $V^4$ to the adjacent $E^1$, $E^2$, $E^3$ or $E^4$;
the first linking position and the second linking position are adjacent to each other; and
the additional substituents are present in numbers capable of bonding according to a stoichiometric ratio and are each independently selected from the group consisting of deuterium, halogen, cyano, $-NO_2$, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, alkynyl having 2 to 30 carbon atoms, allyl having 3 to 30 carbon atoms, aryl having 6 to 30 carbon atoms, heteroaryl having 2 to 30 carbon atoms, $-B(R^{201})(R^{202})$, $-C(R^{203})(R^{204})(R^{205})$, $Si(R^{206})(R^{207})(R^{208})$, $-Ge(R^{209})(R^{210})(R^{211})$, - $N(R^{212})(R^{213})$, $-P(R^{214})(R^{215})$, $-PO(R^{216})(R^{217})$, $-O(R^{218})$, $-S(R^{219})$, $-SO(R^{221})$, $-SO_2(R^{221})$, $Se(R^{222})$, $-SeO(R^{223})$, $-SeO_2(R^{224})$ and combinations thereof, and $R^{201}$ to $R^{224}$ are each independently hydrogen, deuterium, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, aryl having 6 to 30 carbon atoms, or heteroaryl having 2 to 30 carbon atoms.

**2.** The organic light-emitting diode of claim 1, wherein M is Rh, Ir, Pd, Pt, Ni, Rh, Co or Au.

**3.** The organic light-emitting diode of claim 1, wherein Chemical Formula 1 is any one of chemical formulae represented by the following B-1 to B-28:

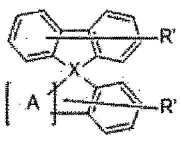
B-1

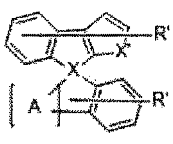
B-2

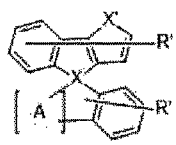
B-3

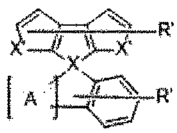
B-4

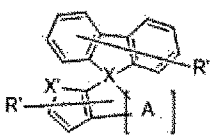
B-5

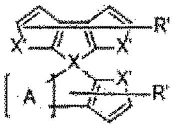
B-6

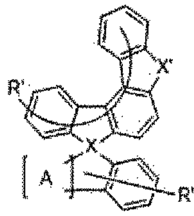
B-7

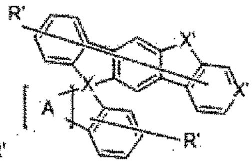
B-8

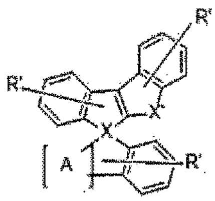
B-9

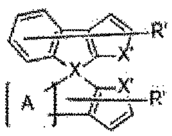
B-10

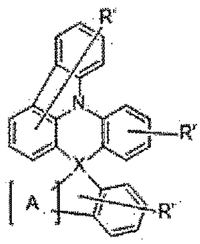
B-11

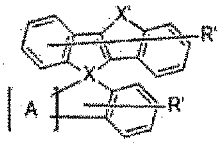
B-12

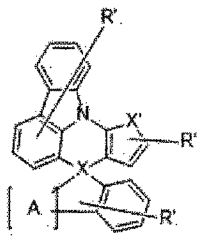
B-13

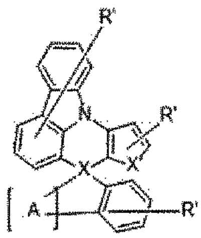
B-14

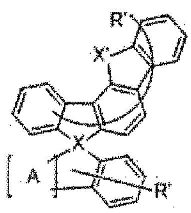
B-15

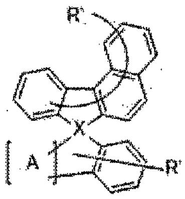
B-16

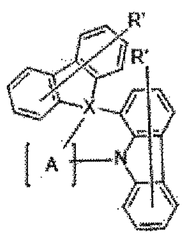
B-17

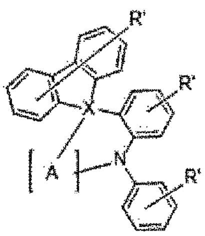
B-18

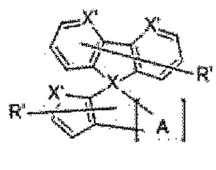
B-19

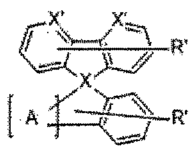
B-20

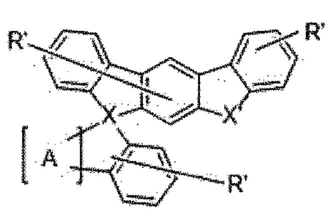
B-21

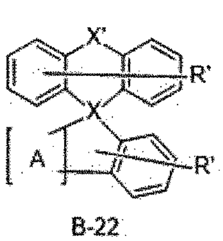
B-22

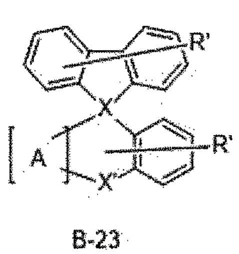
B-23

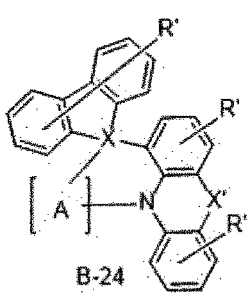
B-24

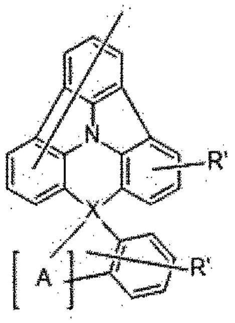
B-25

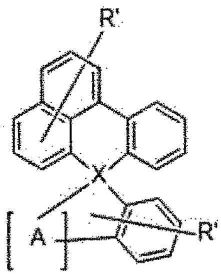
B-26

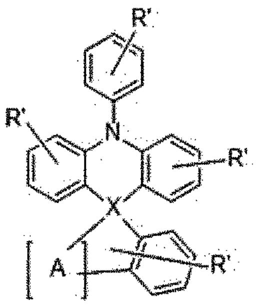
B-27

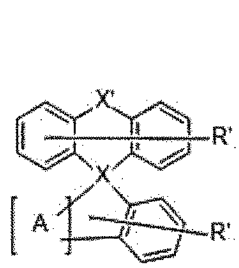
B-28

in B-1 to B-28,

A and X have the same definitions as in Chemical Formula 1;
X's linked by =X'- are each independently =C($Ar^7$)-, =N-or =B-;
X's linked by -X'- are each independently -O-, -S-, - Se-, -C($Ar^7$)($Ar^8$)-, -Si($Ar^7$)($Ar^8$) or -N($Ar^7$)-;
$Ar^7$ and $Ar^8$ in the definition of X' are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and $Ar^7$ and $Ar^8$ are optionally linked to each other to form a ring, or each optionally linked to an adjacent ring to form a fused ring;
R's are present in numbers capable of bonding according to a stoichiometric ratio, and are each independently at least one selected from the group consisting of hydrogen, deuterium, halogen, cyano, $-NO_2$, alkyl having 1 to 30 carbon atoms unsubstituted or substituted with an additional substituent, alkenyl having 2 to 30 carbon atoms unsubstituted or substituted with an additional substituent, alkynyl having 2 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heteroalkenyl having 2 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, allyl having 3 to 30 carbon atoms unsubstituted or substituted with an additional substituent, aryl having 6 to 30 carbon atoms unsubstituted or substituted with an additional substituent, heteroaryl having 2 to 30 carbon atoms unsubstituted or substituted with an additional substituent, -B($R^{101}$)($R^{102}$), -C($R^{103}$)($R^{104}$)($R^{105}$), - Si($R^{106}$)($R^{107}$)($R^{108}$), -Ge($R^{109}$)($R^{110}$)($R^{111}$), -N($R^{112}$)($R^{113}$), - P($R^{114}$)($R^{115}$), -PO($R^{116}$)($R^{117}$), -O($R^{118}$), -S($R^{119}$), -SO($R^{120}$), - $SO_2$($R^{121}$), Se($R^{122}$), -SeO($R^{123}$) -$SeO_2$($R^{124}$) and combinations thereof;
$R^{101}$ to $R^{124}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and at least two of $R^{101}$ to $R^{124}$ linked to one atom are optionally linked to form a ring; and
the additional substituent has the same definition as in Chemical Formula 1.

**4.** The organic light-emitting diode of claim 1, wherein A is represented by the following Chemical Formula 3:

<Chemical Formula 3>

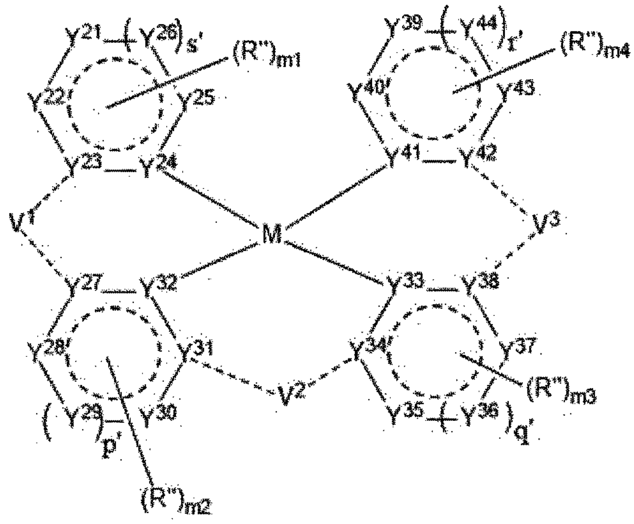

in Chemical Formula 3,

M is Pt;
$V^1$, $V^2$ and $V^3$ have the same definitions as in Chemical Formula 2;
s', p', q' and r' are each 0 or 1;
m1, m2, m3 and m4 are each an integer of 1 to 5;
$Y^{21}$ to $Y^{44}$ are each independently B, N, C, O, P, Si, S, Ge or Se, and the ring including a circle marked by a dotted line optionally does not have a conjugated structure, or partially or fully has a conjugated structure;
R"s are each independently at least one selected from the group consisting of hydrogen, deuterium, halogen, cyano, $-NO_2$, alkyl having 1 to 30 carbon atoms unsubstituted or substituted with an additional substituent, alkenyl having 2 to 30 carbon atoms unsubstituted or substituted with an additional substituent, alkynyl having 2 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heteroalkenyl having 2 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, allyl having 3 to 30 carbon atoms unsubstituted or substituted with an additional substituent, aryl having 6 to 30 carbon atoms unsubstituted or substituted with an additional substituent, heteroaryl having 2 to 30 carbon atoms unsubstituted or substituted with an additional substituent, $-B(R^{301})(R^{302})$, - $C(R^{303})(R^{304})(R^{305})$, $-Si(R^{306})(R^{307})(R^{308})$, $-Ge(R^{309})(R^{310})(R^{311})$- $N(R^{312})(R^{313})$, $-P(R^{314})(R^{315})$, $-PO(R^{316})(R^{317})$, $-Q(R^{318})$, $-S(R^{319})$, $-SO(R^{320})$, $-SO_2(R^{321})$, $Se(R^{322})$, $-SeO(R^{323})$, $-SeO_2(R^{324})$ and combinations thereof;
$R^{301}$ to $R^{324}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and at least two of $R^{301}$ to $R^{324}$ linked to one atom are optionally linked to form a ring; and
the additional substituent has the same definition as in Chemical Formula 1.

**5.** The organic light-emitting diode of claim 1, wherein A is represented by any one of the following Chemical Formula 4 to Chemical Formula 8:

<Chemical Formula 4>

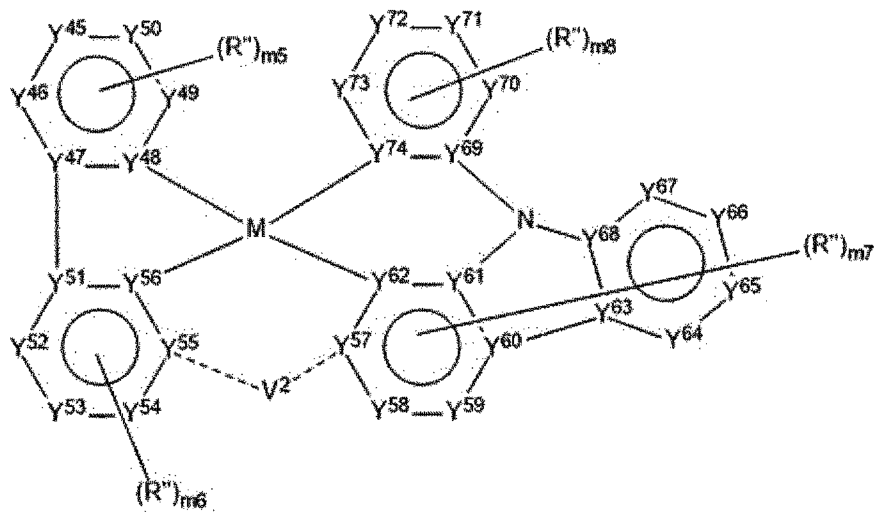

<Chemical Formula 5>

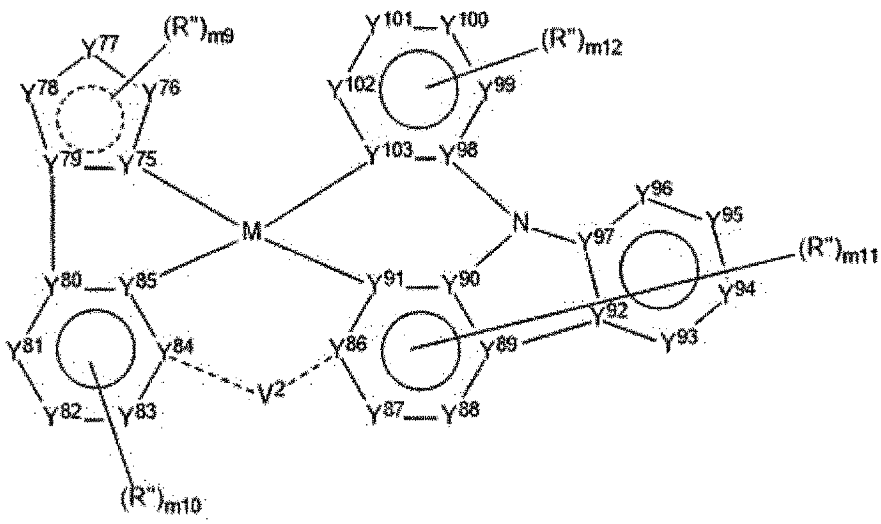

<Chemical Formula 6>

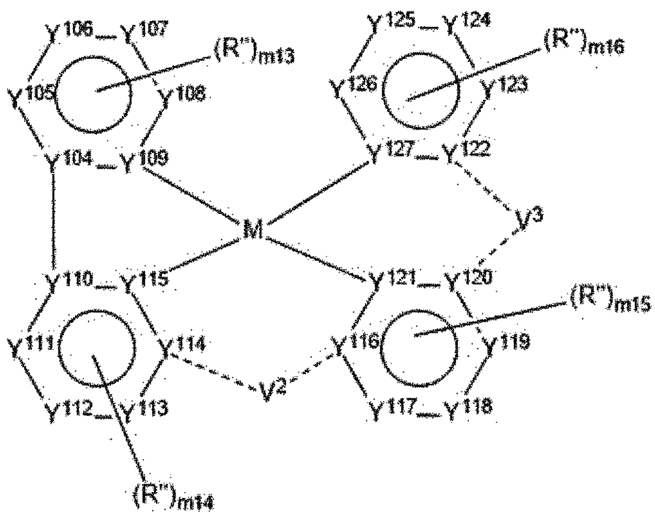

<Chemical Formula 7>

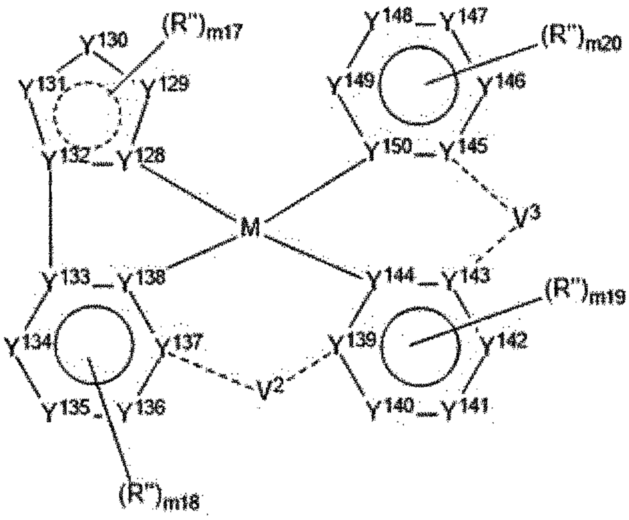

<Chemical Formula 8>

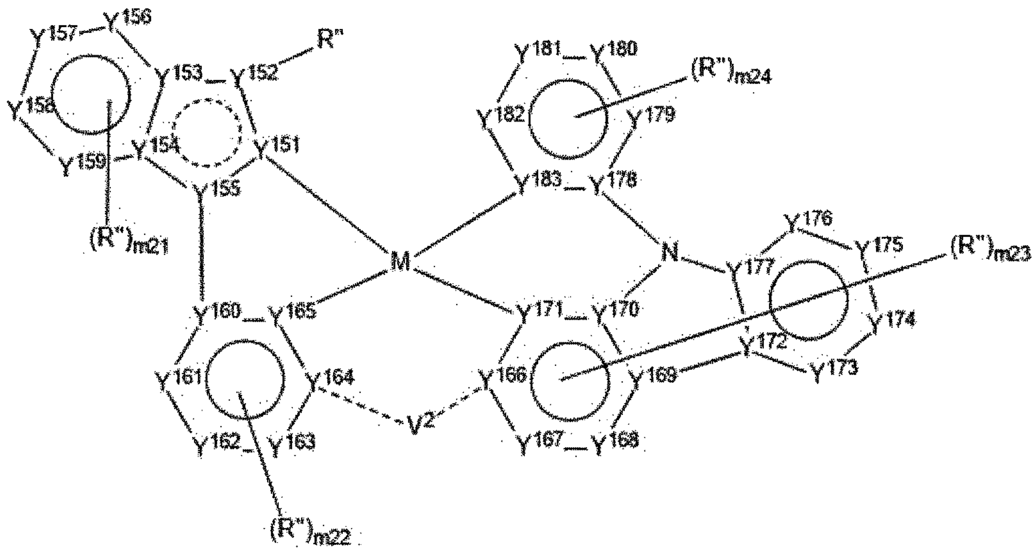

in Chemical Formula 4 to Chemical Formula 8,

M is Pt;
$V^2$ and $V^3$ are each independently not present, or a single bond, -B($Ar^5$)-, -N($Ar^5$)-, -O-, -S- or -Se-, and $Ar^5$s are each independently aryl having 6 to 30 carbon atoms unsubstituted or substituted with an additional substituent, heteroaryl having 2 to 30 carbon atoms unsubstituted or substituted with an additional substituent, alkyl having 1 to 30 carbon atoms unsubstituted or substituted with an additional substituent, cycloalkyl having 3 to 30 carbon atoms unsubstituted or substituted with an additional substituent, heterocycloalkyl having 2 to 30 carbon atoms unsubstituted or substituted with an additional substituent, cycloalkenyl having 3 to 30 carbon atoms unsubstituted or substituted with an additional substituent, or heterocycloalkenyl having 2 to 30 carbon atoms unsubstituted or substituted with an additional substituent;
m5, m6, m8, m10, m12, m13, m14, m18, m21, m22 and m24 are each an integer of 1 to 4;
m15, m16, m19 and m20 are each an integer of 1 to 5;
m7, m11 and m23 are each an integer of 1 to 7;
m9 and m17 are each an integer of 1 to 3;
$Y^{45}$ to $Y^{74}$, $Y^{80}$ to $Y^{127}$, $Y^{133}$ to $Y^{150}$, and $Y^{156}$ to $Y^{183}$ are each independently B, N or C;
$Y^{75}$ to $Y^{79}$, $Y^{128}$ to $Y^{132}$, and $Y^{151}$ to $Y^{155}$ are each independently B, N, C, O, S, Se, Te, Si, Ge or Sn;

the ring including a circle marked by a dotted line in Chemical Formula 5, Chemical Formula 7 and Chemical Formula 8 optionally does not have a conjugated structure, or partially or fully has a conjugated structure;

R"s are each independently at least one selected from the group consisting of hydrogen, deuterium, halogen, cyano, $-NO_2$, alkyl having 1 to 30 carbon atoms unsubstituted or substituted with an additional substituent, alkenyl having 2 to 30 carbon atoms unsubstituted or substituted with an additional substituent, alkynyl having 2 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heteroalkenyl having 2 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, allyl having 3 to 30 carbon atoms unsubstituted or substituted with an additional substituent, aryl having 6 to 30 carbon atoms unsubstituted or substituted with an additional substituent, heteroaryl having 2 to 30 carbon atoms unsubstituted or substituted with an additional substituent, $-B(R^{301})(R^{302})$, $-C(R^{303})(R^{304})(R^{305})$, $-Si(R^{306})(R^{307})(R^{308})$, $-Ge(R^{309})(R^{310})(R^{311})$, $-N(R^{312})(R^{313})$, $-P(R^{314})(R^{315})$, $-PO(R^{316})(R^{317})$, $-O(R^{318})$, $-S(R^{319})$, $-SO(R^{320})$, $-SO_2(R^{321})$, $Se(R^{322})$, $-SeO(R^{323})$, $-SeO_2(R^{324})$ and combinations thereof;

$R^{301}$ to $R^{324}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and at least two of $R^{301}$ to $R^{324}$ linked to one atom are optionally linked to form a ring; and

the additional substituent has the same definition as in Chemical Formula 1.

**6.** The organic light-emitting diode of claim 1, wherein A is represented by any one of the following Structural Formulae A-1 to A-27:

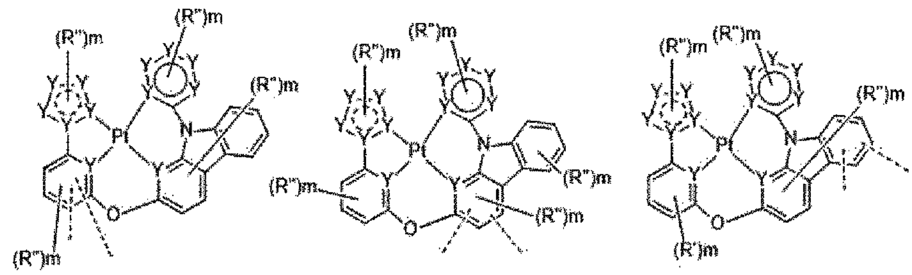

A-1 A-2 A-3

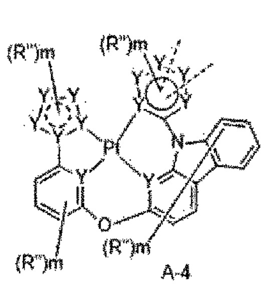

A-4

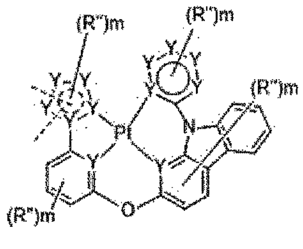

A-5

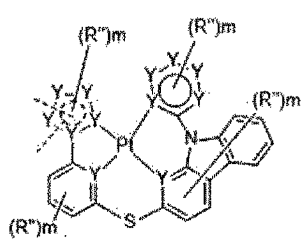

A-6

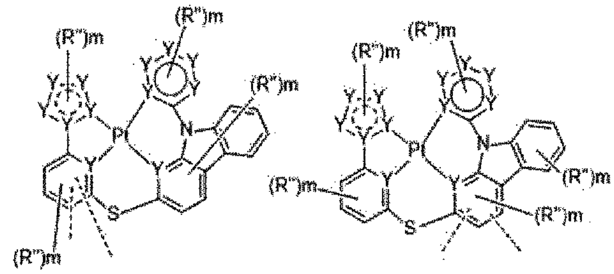

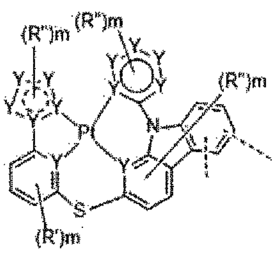

A-7 A-8 A-9

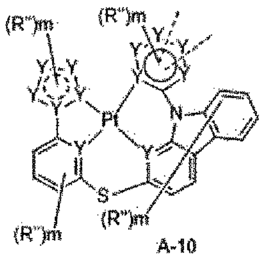

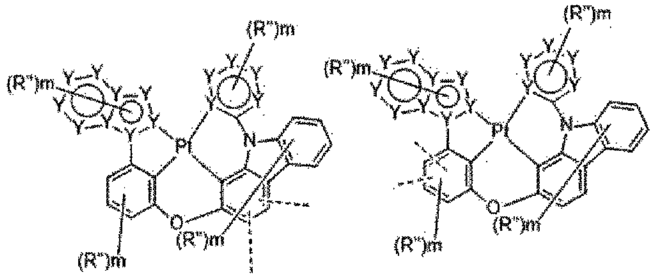

A-10 A-11 A-12

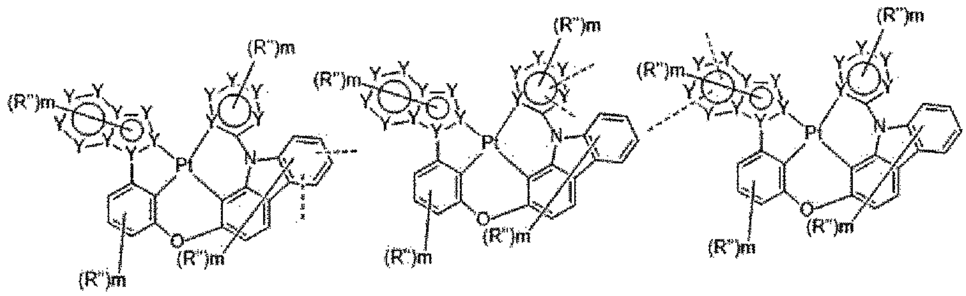

A-13 A-14 A-15

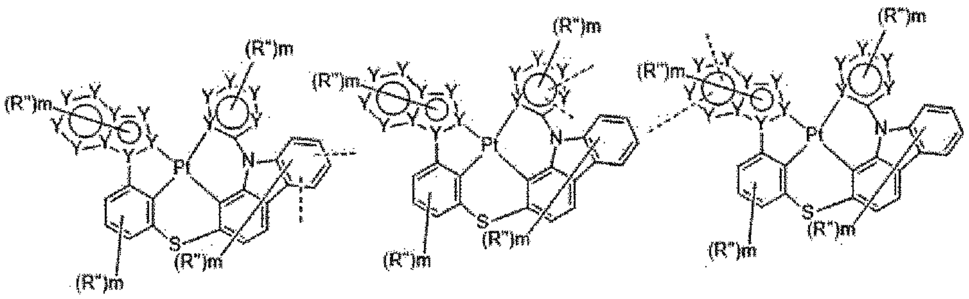

A-13 A-14 A-15

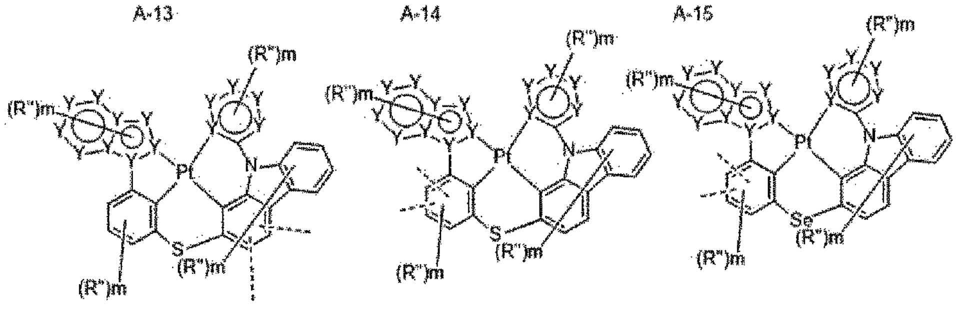

A-16 A-17 A-18

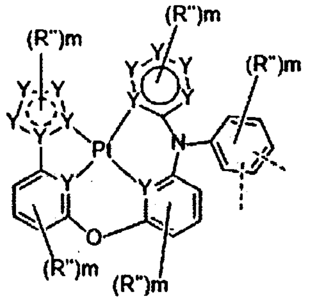

A-19

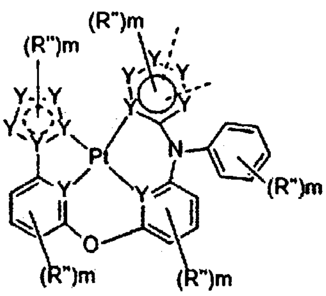

A-20

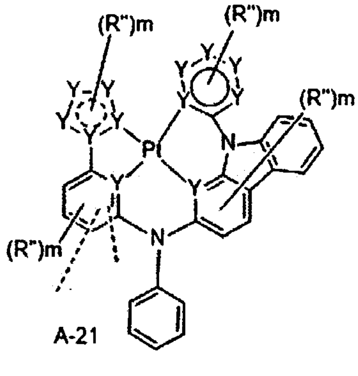

A-21

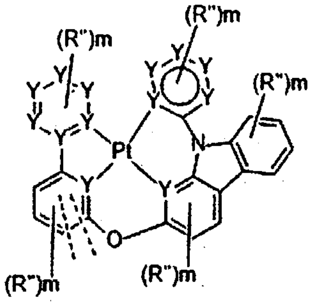

A-22

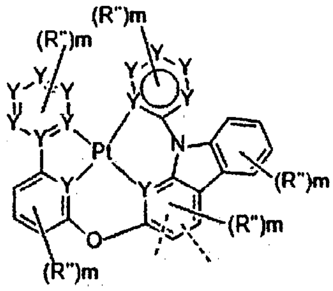

A-23

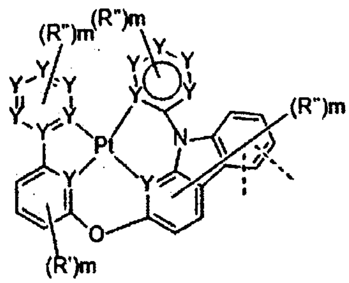

A-24

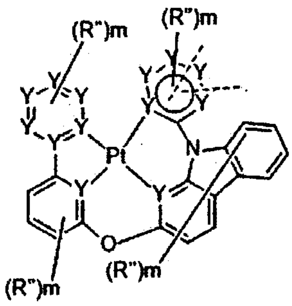

A-25

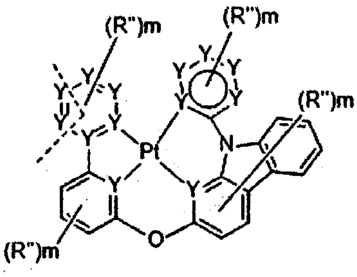

A-26

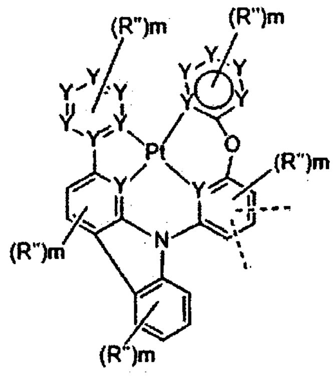

A-27

in A-1 to A-27,

Ys are each independently B, N, C, O, P, Si, S, Ge or Se;
m is an integer of 0 to a maximum number capable of having according to a stoichiometric ratio;
R"s are each independently at least one selected from the group consisting of hydrogen, deuterium, halogen, cyano, $-NO_2$, alkyl having 1 to 30 carbon atoms unsubstituted or substituted with an additional substituent, alkenyl having 2 to 30 carbon atoms unsubstituted or substituted with an additional substituent, alkynyl having 2 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heteroalkenyl having 2 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, allyl having 3 to 30 carbon atoms unsubstituted or substituted with an additional substituent, aryl having 6 to 30 carbon atoms unsubstituted or substituted with an additional substituent, heteroaryl having 2 to 30 carbon atoms unsubstituted or substituted with an additional substituent, $-B(R^{301})(R^{302})$, $-C(R^{303})(R^{304})(R^{305})$, $-Si(R^{306})(R^{307})(R^{308})$, $-Ge(R^{309})(R^{310})(R^{311})$, $-N(R^{312})(R^{313})$, $-P(R^{314})(R^{315})$, $-PO(R^{316})(R^{317})$, $-O(R^{318})$, $-S(R^{319})$, $-SO(R^{320})$, $-SO_2(R^{321})$, $Se(R^{322})$, $-SeO(R^{323})$, $-SeO_2(R^{324})$ and combina-

tions thereof;
$R^{301}$ to $R^{324}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent, heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent, or heteroaryl having 2 to 30 carbon atoms unsubstituted or substituted with an additional substituent, and at least two of $R^{301}$ to $R^{324}$ linked to one atom are optionally linked to form a ring; and
the additional substituent has the same definition as in Chemical Formula 1.

**7.** The organic light-emitting diode of claim 1, wherein at least one of $Y^6$ to $Y^{15}$; and atoms of Z linked to $Y^6$ and $Y^{11}$ is an atom having an unshared electron pair included in a wave function of HOMO or LUMO of the charge-stabilizing moiety; or

at least one of $Y^6$ to $Y^{15}$ has R represented by the following Chemical Formula 9 or the following Chemical Formula 10:

<Chemical Formula 9>

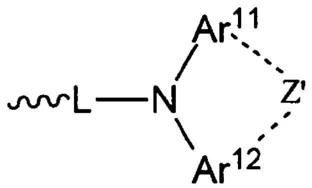

<Chemical Formula 10>

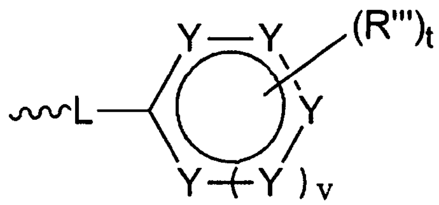

in Chemical Formula 9 and Chemical Formula 10,
L is a single bond, or a divalent group selected from the group consisting of alkylene having 1 to 20 carbon atoms, cycloalkylene having 3 to 20 carbon atoms, cycloalkenylene having 3 to 20 carbon atoms, heteroalkylene having 1 to 20 carbon atoms, heterocycloalkylene having 2 to 20 carbon atoms, heterocycloalkenylene having 2 to 20 carbon atoms, alkenylene having 2 to 20 carbon atoms, -O-, -S-, -P($R^{401}$)-, -PO($R^{402}$)-, arylene having 6 to 20 carbon atoms, heteroarylene having 5 to 20 carbon atoms and combinations thereof;
$Ar^{11}$ and $Ar^{12}$ are each independently a monovalent group or a divalent group of saturated or unsaturated aliphatic hydrocarbon having 1 to 20 carbon atoms unsubstituted or substituted with an additional substituent; saturated or unsaturated heteroatom-containing aliphatic hydrocarbon having 1 to 20 carbon atoms unsubstituted or substituted with an additional substituent; an aromatic carbon ring having 5 to 20 carbon atoms unsubstituted or substituted with an additional substituent; an aromatic heteroring having 2 to 20 carbon atoms unsubstituted or substituted with an additional substituent; a saturated or unsaturated alicyclic carbon ring having 3 to 20 carbon atoms unsubstituted or substituted with an additional substituent; or a saturated or unsaturated alicyclic heteroring having 2 to 20 carbon atoms unsubstituted or substituted with an additional substituent;
Z' is not present, or a single bond, -B($Ar^{13}$)-, - C($Ar^{13}$)($Ar^{14}$)-, -Si($Ar^{13}$)($Ar^{14}$)-, -Ge($Ar^{13}$)($Ar^{14}$)-, -N($Ar^{13}$)-, - P($Ar^{13}$)-, -PO($Ar^{13}$)-, -O-, -S-, -SO-, -$SO_2$-, -Se-, -SeO-, - $SeO_2$-, -CO-, -CS- or -CSe-, and herein, $Ar^{13}$ and $Ar^{14}$ are each independently hydrogen, deuterium, halogen, alkyl having 1 to 30 carbon atoms unsubstituted or substituted with an additional substituent, cycloalkyl having 3 to 30 carbon atoms unsubstituted or substituted with an additional substituent, cycloalkenyl having 3 to 30 carbon atoms unsubstituted or substituted with an additional substituent, heteroalkyl having 1 to 30 carbon atoms unsubstituted or substituted with an additional substituent,

heterocycloalkyl having 2 to 30 carbon atoms unsubstituted or substituted with an additional substituent, heterocycloalkenyl having 2 to 30 carbon atoms unsubstituted or substituted with an additional substituent, aryl having 6 to 30 carbon atoms unsubstituted or substituted with an additional substituent or heteroaryl having 2 to 30 carbon atoms unsubstituted or substituted with an additional substituent, and $Ar^{13}$ and $Ar^{14}$ are optionally linked to each other to form a ring, or each optionally linked to any one of $Ar^{11}$ and $Ar^{12}$ to form a fused ring;
when Z' is not present, $Ar^{11}$ and $Ar^{12}$ are not directly linked;
when Z' is a single bond, $Ar^{11}$ and $Ar^{12}$ are linked by a single bond;
t is an integer of 0 to 5;
v is 0 or 1;
R' "s are each independently at least one selected from the group consisting of hydrogen, deuterium, halogen, cyano, $-NO_2$, alkyl having 1 to 30 carbon atoms, heteroalkyl having 1 to 30 carbon atoms, cycloalkyl having 3 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, alkynyl having 2 to 30 carbon atoms, allyl having 3 to 30 carbon atoms, aryl having 6 to 30 carbon atoms, heteroaryl having 2 to 30 carbon atoms, $-B(R^{501})(R^{502})$, $-C(R^{503})(R^{504})(R^{505})$, $-Si(R^{506})(R^{507})(R^{508})$, $-Ge(R^{509})(R^{510})(R^{511})$, $-N(R^{512})(R^{513})$, $-P(R^{514})(R^{515})$, $-PO(R^{516})(R^{517})$, $-O(R^{518})$, $-S(R^{519})$, $-SO(R^{520})$, $-SO_2(R^{521})$, $Se(R^{522})$, $-SeO(R^{523})$, $-SeO_2(R^{524})$ and combinations thereof, and herein, at least two R'"s are optionally linked to each other to form a ring;
$R^{401}$ to $R^{402}$ and $R^{501}$ to $R^{524}$ are each independently hydrogen, deuterium, halogen, alkyl having 1 to 30 carbon atoms, cycloalkyl having 3 to 30 carbon atoms, heteroalkyl having 1 to 30 carbon atoms, heterocycloalkyl having 2 to 30 carbon atoms, aryl having 6 to 30 carbon atoms, or heteroaryl having 2 to 30 carbon atoms, and at least two of $R^{401}$ to $R^{402}$ and $R^{501}$ to $R^{524}$ linked to one atom are optionally linked to form a ring;
Ys are each independently nitrogen, oxygen, sulfur or carbon;

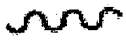

represents a linking site;
the additional substituents are present in numbers capable of bonding according to a stoichiometric ratio and are each independently selected from the group consisting of deuterium, halogen, cyano, $-NO_2$, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, alkynyl having 2 to 30 carbon atoms, allyl having 3 to 30 carbon atoms, aryl having 6 to 30 carbon atoms, heteroaryl having 2 to 30 carbon atoms, $-B(R^{201})(R^{202})$, $-C(R^{203})(R^{204})(R^{205})$, $Si(R^{206})(R^{207})(R^{208})$, $-Ge(R^{209})(R^{210})(R^{211})$, $-N(R^{212})(R^{213})$, $-P(R^{214})(R^{215})$, $-PO(R^{216})(R^{217})$, $-O(R^{218})$, $-S(R^{219})$, $-SO(R^{221})$, $-SO_2(R^{221})$, $Se(R^{222})$, $-SeO(R^{223})$, $-SeO_2(R^{224})$ and combinations thereof, and $R^{201}$ to $R^{224}$ are each independently hydrogen, deuterium, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, heterocycloalkenyl having 2 to 30 carbon atoms, aryl having 6 to 30 carbon atoms, or heteroaryl having 2 to 30 carbon atoms;
however, in Chemical Formula 10, L or R' " includes at least one atom having an unshared electron pair included in a wave function of HOMO or LUMO of the charge-stabilizing moiety, or at least one of Ys is nitrogen, oxygen or sulfur.

**8.** The organic light-emitting diode of claim 1, wherein at least one R is represented by any one of structures of the following Chemical Formulae D-1 to D-38:

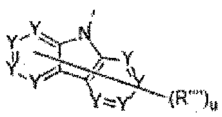

D-1

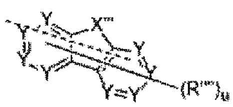

D-2

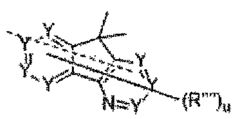

D-3

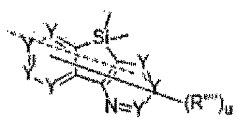

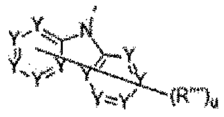

D-4 D-5

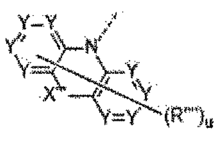

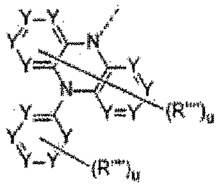

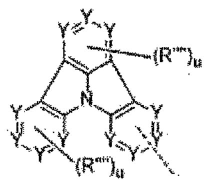

D-6 D-7 D-8

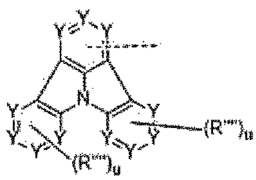

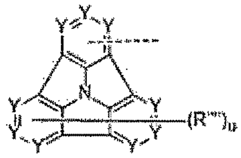

D-9 D-10

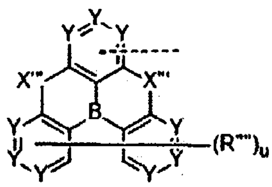

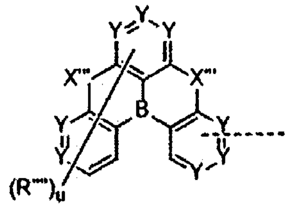

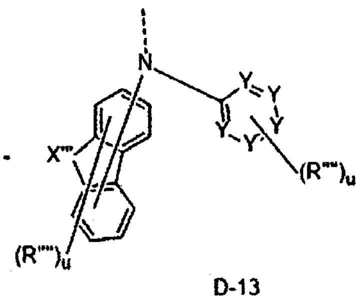

D-11 D-12 D-13

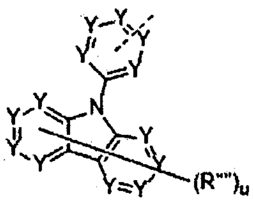

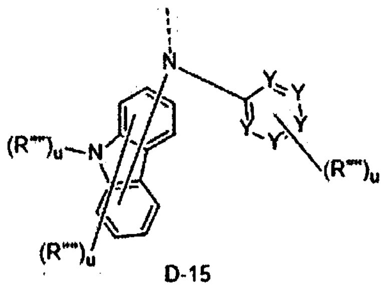

D-14 D-15

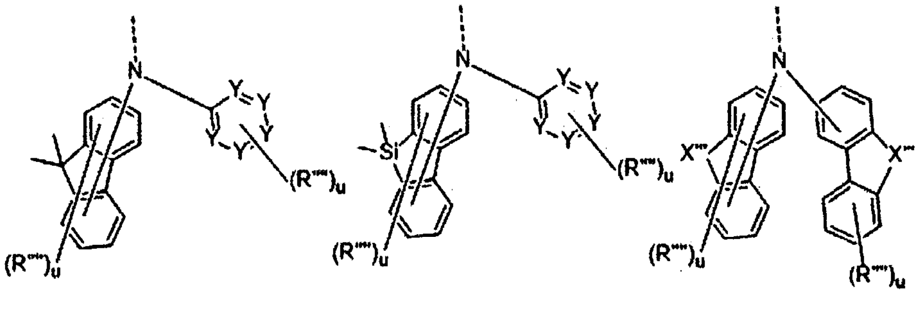

D-16 D-17 D-18

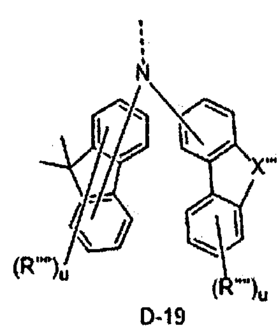

D-19

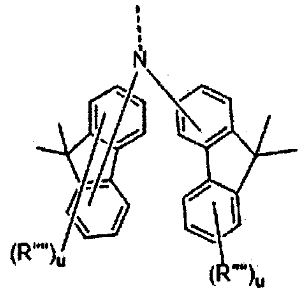

D-20

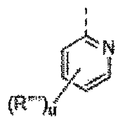

D-21

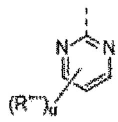

D-22

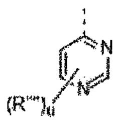

D-23

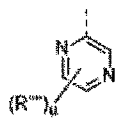

D-24

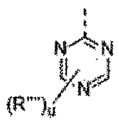

D-25

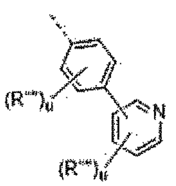

D-26

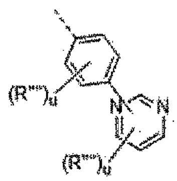

D-27

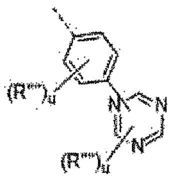

D-28

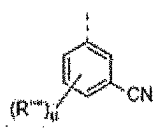

D-29

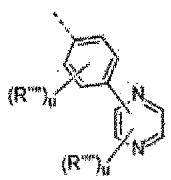

D-30

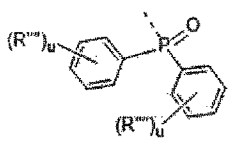

D-31

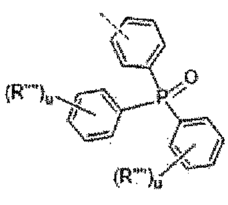

D-32

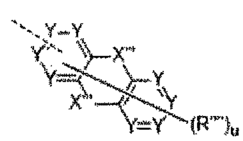

D-33

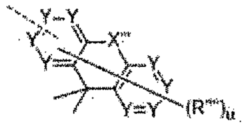

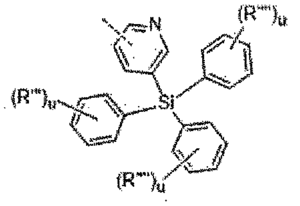

D-34 D-35

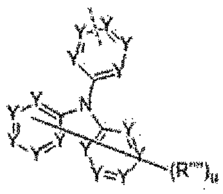

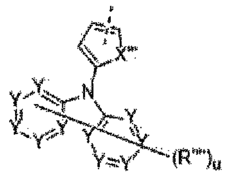

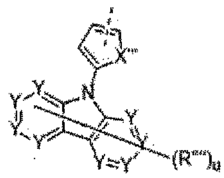

D-36 D-37 D-38

in Chemical Formulae D-1 to D-38,

Ys are each independently carbon or nitrogen;
X' "s are each independently oxygen, nitrogen, sulfur or selenium;
R""s are each independently selected from the group consisting of hydrogen, deuterium, halogen, cyano, $-NO_2$, alkyl having 1 to 30 carbon atoms, cycloalkyl having 3 to 30 carbon atoms, heteroalkyl having 1 to 30 carbon atoms, heterocycloalkyl having 2 to 30 carbon atoms, alkenyl having 2 to 30 carbon atoms, cycloalkenyl having 3 to 30 carbon atoms, heteroalkenyl having 2 to 30 carbon atoms, alkynyl having 2 to 30 carbon atoms, allyl having 3 to 30 carbon atoms, aryl having 6 to 30 carbon atoms, heteroaryl having 2 to 30 carbon atoms, $-B(R^{601})(R^{602})$, $-C(R^{603})(R^{604})(R^{605})$, - $Si(R^{606})(R^{607})(R^{608})$, $-Ge(R^{609})(R^{610})(R^{611})$, $-N(R^{612})(R^{613})$, - $P(R^{614})(R^{615})$, $-PO(R^{616})(R^{617})$, $-O(R^{618})$, $-S(R^{619})$, $-SO(R^{620})$, - $SO_2(R^{621})$, $Se(R^{622})$, $-SeO(R^{623})$, $-SeO_2(R^{624})$ and combinations thereof, and $R^{601}$ to $R^{624}$ are each independently selected from hydrogen, deuterium, alkyl having 1 to 30 carbon atoms, cycloalkyl having 3 to 30 carbon atoms, heterocycloalkyl having 2 to 30 carbon atoms, aryl having 6 to 30 carbon atoms, heteroaryl having 2 to 30 carbon atoms and combinations thereof;
us are each independently an integer of 0 to 20; and
the dotted line represents a linking site.

**9.** The organic light-emitting diode of claim 1, wherein the complex light-emitting compound includes at least one deuterium.

**10.** The organic light-emitting diode of claim 1, wherein the complex light-emitting compound represented by Chemical Formula 1 is any one of the following compounds:

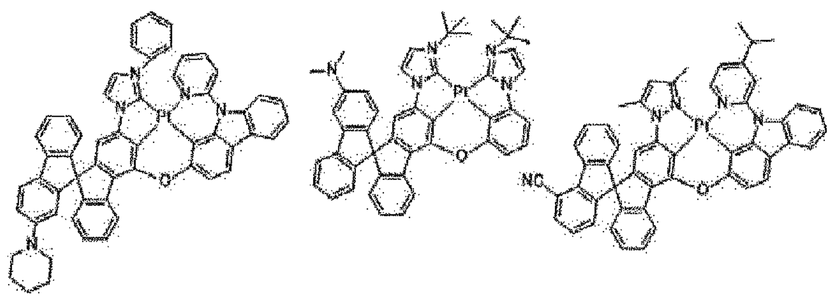

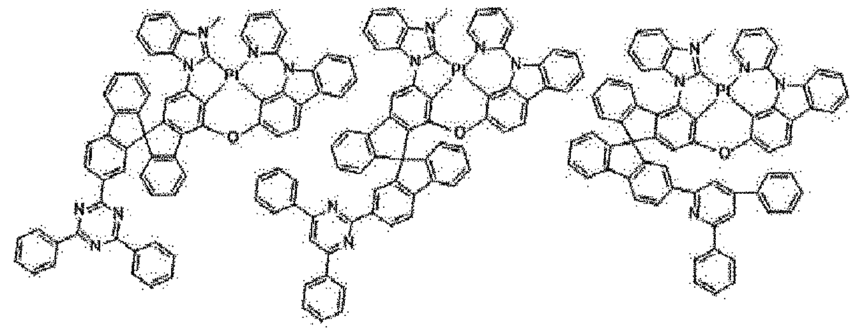

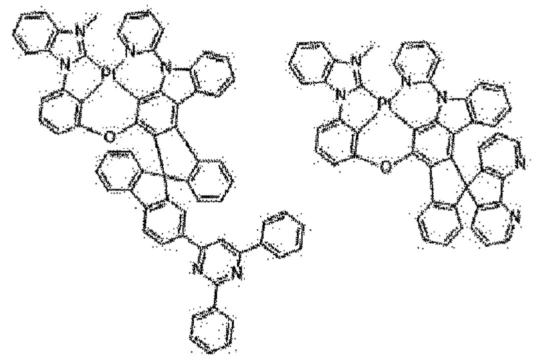

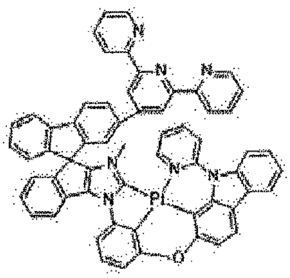

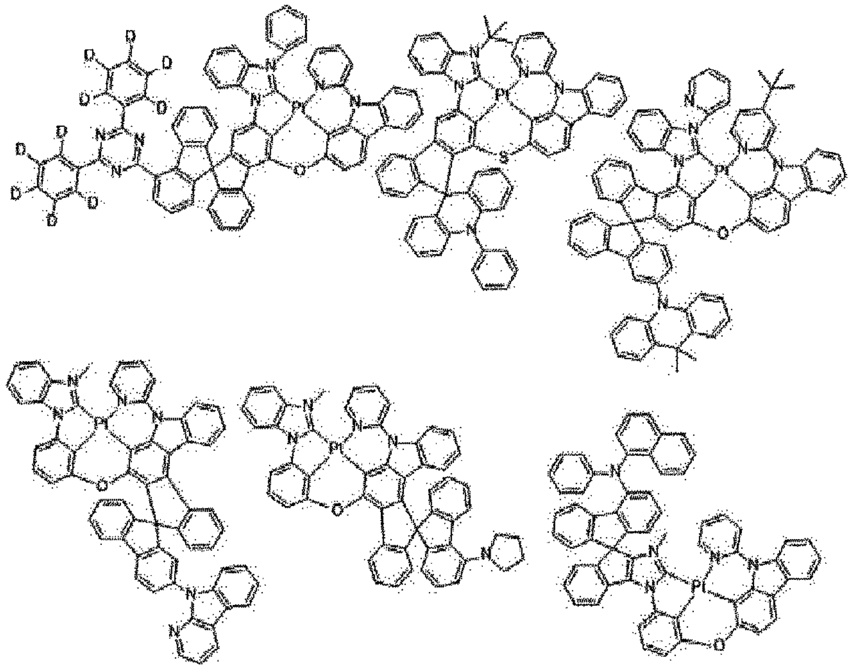

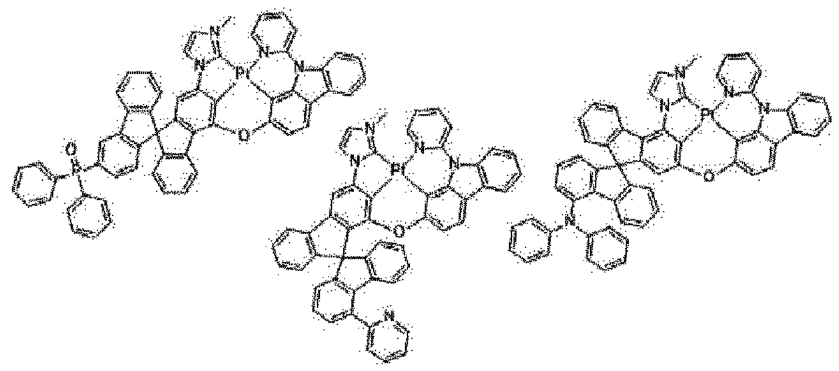

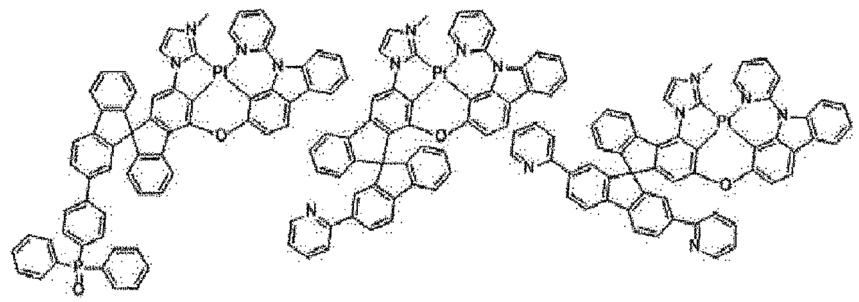

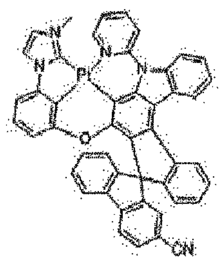

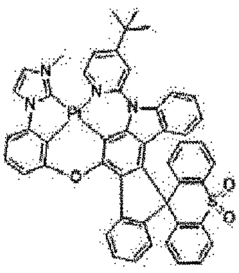

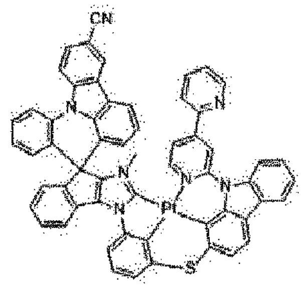

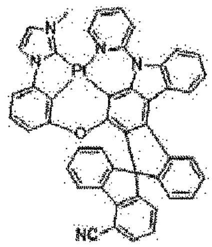

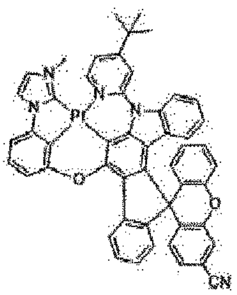

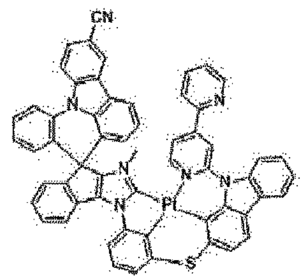

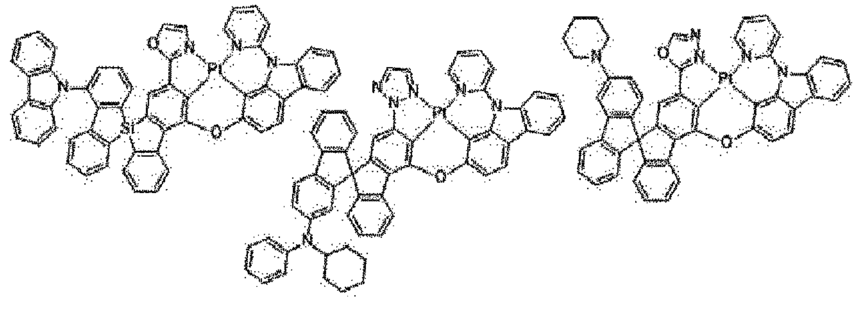

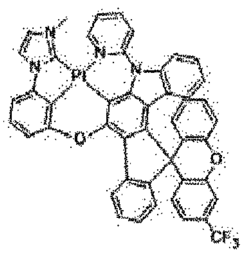

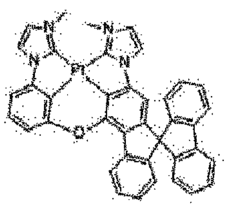

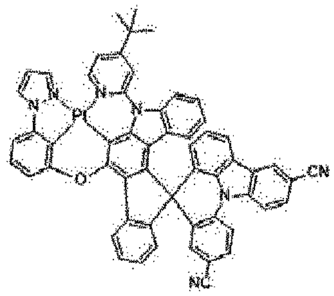

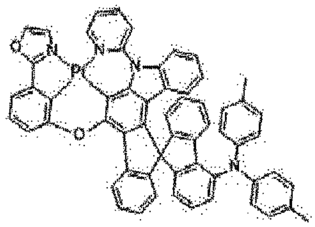

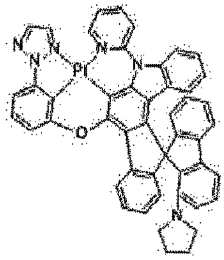

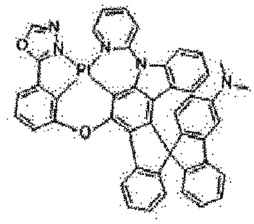

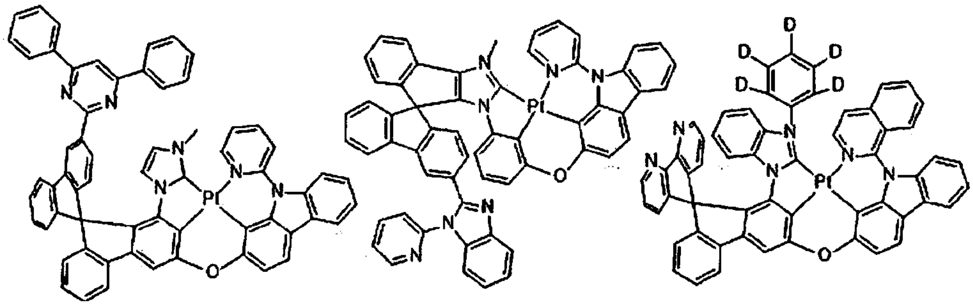

.

11. The organic light-emitting diode of claim 1, wherein the light-emitting layer includes at least two types of the complex light-emitting compound.

12. The organic light-emitting diode of claim 1, wherein the light-emitting layer further includes at least one selected from the group consisting of a host, an additional dopant and combinations thereof.

13. The organic light-emitting diode of claim 1, wherein light-emitting layer further includes a phosphorescent material including Ir or Pt.

14. The organic light-emitting diode of claim 1, wherein the light-emitting layer further includes a delayed fluorescent material in which an energy difference between a singlet and a triplet is 0.3 eV or less.

15. The organic light-emitting diode of claim 1, which is a tandem-type organic light-emitting diode including a plurality of organic light-emitting units, wherein at least one of the plurality of organic light-emitting units includes the light-emitting layer.

【FIG. 1】

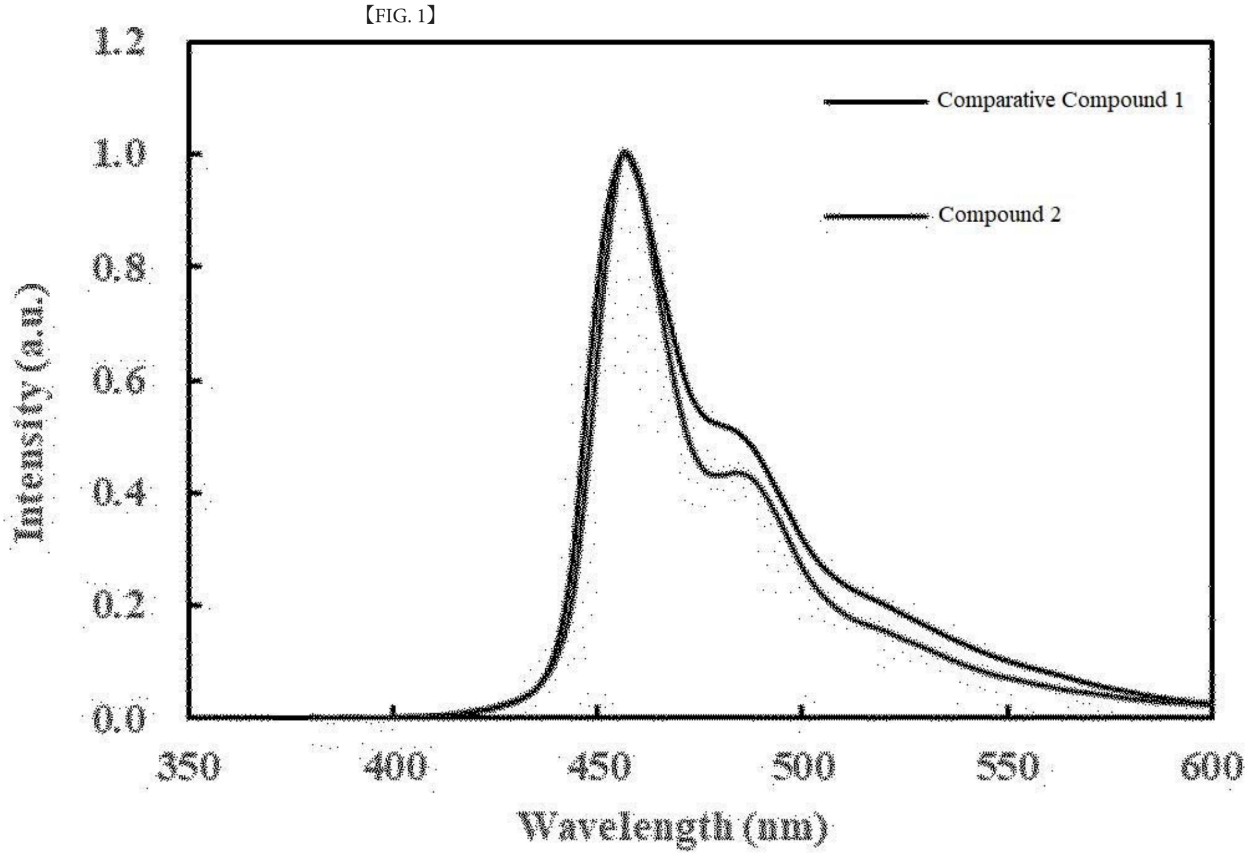
1.2
1.0
0.8
0.6
0.4
0.2
0.0
Intensity (a.u.)
350
400
450
500
550
600
Wavelength (nm)
Comparative Compound 1
Compound 2

**INTERNATIONAL SEARCH REPORT**

International application No.
**PCT/KR2024/001209**

**A. CLASSIFICATION OF SUBJECT MATTER**

**H10K 85/30**(2023.01)i; **H10K 50/11**(2023.01)i; **H10K 50/19**(2023.01)i; **C09K 11/06**(2006.01)i; **H10K 101/20**(2023.01)i

According to International Patent Classification (IPC) or to both national classification and IPC

**B. FIELDS SEARCHED**

Minimum documentation searched (classification system followed by classification symbols)

H10K 85/30(2023.01); C07D 401/14(2006.01); C07D 471/04(2006.01); C07F 15/00(2006.01); C09K 11/06(2006.01); H01L 51/00(2006.01); H10K 50/00(2023.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal), STN (Registry, CAplus) & keywords: 복합 발광 화합물(complex luminescent compound), 비공유 전자쌍(unshared electron pair), 발광 모이어티(luminescent moiety), 전하 안정화 모이어티(charge stabilizing moiety)

**C. DOCUMENTS CONSIDERED TO BE RELEVANT**

| Category* | Citation of document, with indication, where appropriate, of the relevant passages | Relevant to claim No. |
|---|---|---|
| X | CN 114644660 A (ZHEJIANG HUASHENG PHOTOELECTRIC SCIENCE AND TECHNOLOGY LIMITED COMPANY) 21 June 2022 (2022-06-21)<br>See claims 1, 4 and 7-9. | 1-15 |
| A | KR 10-2015-0043225 A (ARIZONA BOARD OF REGENTS ON BEHALF OF ARIZONA STATE UNIVERSITY et al.) 22 April 2015 (2015-04-22)<br>See entire document. | 1-15 |
| A | KR 10-2022-0125864 A (SAMSUNG DISPLAY CO., LTD.) 15 September 2022 (2022-09-15)<br>See entire document. | 1-15 |
| A | CN 109651337 A (AAC TECHNOLOGIES (NANJING) INC.) 19 April 2019 (2019-04-19)<br>See entire document. | 1-15 |

☑ Further documents are listed in the continuation of Box C. ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **07 May 2024** | **07 May 2024** |

Name and mailing address of the ISA/KR

**Korean Intellectual Property Office**
**Government Complex-Daejeon Building 4, 189 Cheongsa-ro, Seo-gu, Daejeon 35208**

Facsimile No. **+82-42-481-8578**

Authorized officer

Telephone No.

Form PCT/ISA/210 (second sheet) (July 2022)

**INTERNATIONAL SEARCH REPORT**

International application No.
**PCT/KR2024/001209**

| C. DOCUMENTS CONSIDERED TO BE RELEVANT | | |
|---|---|---|
| Category* | Citation of document, with indication, where appropriate, of the relevant passages | Relevant to claim No. |
| A | KR 10-2020-0115542 A (THE UNIVERSITY OF HONG KONG) 07 October 2020 (2020-10-07) See entire document. | 1-15 |

Form PCT/ISA/210 (second sheet) (July 2022)

**INTERNATIONAL SEARCH REPORT**
**Information on patent family members**

International application No.
**PCT/KR2024/001209**

| Patent document cited in search report | Publication date (day/month/year) | Patent family member(s) | Publication date (day/month/year) |
|---|---|---|---|
| CN 114644660 A | 21 June 2022 | None | |
| KR 10-2015-0043225 A | 22 April 2015 | CN 104693243 A | 10 June 2015 |
| | | CN 112794870 A | 14 May 2021 |
| | | JP 2015-081257 A | 27 April 2015 |
| | | JP 2020-196736 A | 10 December 2020 |
| | | JP 2022-121471 A | 19 August 2022 |
| | | JP 6804823 B2 | 23 December 2020 |
| | | JP 7092830 B2 | 28 June 2022 |
| | | KR 10-2023-0053571 A | 21 April 2023 |
| | | KR 10-2521843 B1 | 13 April 2023 |
| | | US 10566553 B2 | 18 February 2020 |
| | | US 11189808 B2 | 30 November 2021 |
| | | US 2015-0105556 A1 | 16 April 2015 |
| | | US 2017-0012224 A1 | 12 January 2017 |
| | | US 2018-0301641 A1 | 18 October 2018 |
| | | US 2020-0152891 A1 | 14 May 2020 |
| | | US 2022-0069242 A1 | 03 March 2022 |
| | | US 9385329 B2 | 05 July 2016 |
| | | US 9947881 B2 | 17 April 2018 |
| KR 10-2022-0125864 A | 15 September 2022 | CN 115010762 A | 06 September 2022 |
| | | US 2022-0310943 A1 | 29 September 2022 |
| CN 109651337 A | 19 April 2019 | None | |
| KR 10-2020-0115542 A | 07 October 2020 | CN 111788212 A | 16 October 2020 |
| | | CN 111788212 B | 10 November 2023 |
| | | DE 112019000529 T5 | 24 December 2020 |
| | | JP 2021-511335 A | 06 May 2021 |
| | | US 2021-0261588 A1 | 26 August 2021 |
| | | WO 2019-144845 A1 | 01 August 2019 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **C. W. TANG**. *Appl. Phys. Lett*, 1987, vol. 51, 913
- *J. Appl. Phys.*, 1989, vol. 65, 3610